# EUROPEAN PATENT APPLICATION

(11) **EP 1 918 969 A1**
(43) Date of publication of application: **07.05.2008**
(21) Application number: 07014339.1
(22) Date of filing: 20.07.2007
(51) Int. Cl.: H01J 37/32

(54) **Mask etch plasma reactor with backside optical sensors and multiple frequency control of etch distribution**

(30) Priority: 30.10.2006 US 589343
(71) Applicant: Applied Materials, Inc., Santa Clara, CA 95054 (US)
(72) Inventor: Lewington, Richard, Hayward, CA 94544 (US); Paterson, Alexander M., San Jose, CA 95120 (US); Grimbergen, Michael N., Redwood City, CA 94065 (US); Kumar, Ajay, Cupertino, CA 95014 (US)
(74) Representative: Zimmermann, Gerd Heinrich

(57) **Abstract**

A plasma reactor is provided having multiple frequency control of etch parameters. The reactor includes a reactor chamber 10 and a workpiece support 16 within the chamber, the chamber having a ceiling 14 facing the workpiece support, and an inductively coupled source power applicator and a capacitively coupled plasma source power applicator. An array of optical fibers 330 extends through the support surface of the workpiece support to view the workpiece through its bottom surface. Optical sensors 328 are coupled to the output ends of the optical fibers. The reactor further includes a controller 60 responsive to the optical sensors for adjusting the relative amounts of power simultaneously coupled to plasma in the chamber by the inductively coupled plasma source power applicator and the capacitively coupled plasma source power applicator.

## Description

The present invention generally relates to plasma reactors. In particular it relates to a plasma reactor for improved etching uniformity. More specifically, it relates to a plasma reactor for processing a workpiece.
Photolithographic mask fabrication for ultra large scale integrated (ULSI) circuits requires a much higher degree of etch uniformity than semiconductor wafer processing. A single mask pattern generally occupies a four inch square area on a quartz mask. The image of the mask pattern is focused down to the area of a single die (a one inch square) on the wafer and is then stepped across the wafer, forming a single image for each die. Prior to etching the mask pattern into the quartz mask, the mask pattern is written by a scanning electron beam, a time consuming process which renders the cost of a single mask extremely high. The mask etch process is not uniform across the surface of the mask. Moreover, the e-beam written photoresist pattern is itself non-uniform, and exhibits, in the case of 45 nm feature sizes on the wafer, as much as 2-3 nm variation in critical dimension (e.g., line width) across the entire mask. (This variation is the 3σ variance of all measured line widths, for example.) Such non-uniformities in photoresist critical dimension will vary among different mask sources or customers. The mask etch process cannot increase this variation by more than 1 nm, so that the variation in the etched mask pattern cannot exceed 3-4 nm. These stringent requirements arise from the use of diffraction effects in the quartz mask pattern to achieve sharp images on the wafer. It is difficult to meet such requirements with current technology. It will be even more difficult for future technologies, which may involve 22 nm wafer feature sizes. This difficulty is compounded by the phenomenon of etch bias, in which the depletion of the photoresist pattern during mask etch causes a reduction in line width (critical dimension) in the etched pattern on the quartz mask. These difficulties are inherent in the mask etch process because the etch selectivity of typical mask materials (e.g., quartz, chrome, molybdenum silicide) relative to photoresist is typically less than one, so that the mask photoresist pattern is etched during the mask etch process.

Some mask patterns require etching periodic openings into the quartz mask by a precisely defined depth that is critical to achieving the extremely fine phase alignment of interfering light beams during exposure of the wafer through the mask. For example, in one type of phase shift mask, each line is defined by a chrome line with thin quartz lines exposed on each side of the chrome line, the quartz line on one side only being etched to a precise depth that provides a 180 degree phase shift of the light relative to light passing through the un-etched quartz line. In order to precisely control the etch depth in the quartz, the etch process must be closely monitored by periodically interrupting it to measure the etch depth in the quartz. Each such inspection requires removing the mask from the mask etch reactor chamber, removing the photoresist, measuring the etch depth and then estimating the etch process time remaining to reach the target depth based upon the elapsed etch process time, depositing new photoresist, e-beam writing the mask pattern on the resist, reintroducing the mask into the mask etch chamber and restarting the etch process. The estimate of remaining etch time to reach the desired depth assumes that the etch rate remains stable and uniform, and therefore is unreliable. The problems of such a cumbersome procedure include low productivity and high cost as well as increased opportunity for contamination or faults in the photoresist pattern. However, because of the requirement for an accurately controlled etch depth, there has seemed to be no way around such problems.

The small tolerance in critical dimension variation requires extremely uniform distribution of etch rate over the mask surface. In masks requiring precise etch depth in the quartz material, there are two critical dimensions, one being the line width and the other being the etch depth, and uniformity for both types of critical dimension requiring a uniform etch rate distribution across the mask. Non-uniformity in etch rate distribution can be reduced to some extent by employing a source power applicator that can vary the radial distribution of the plasma ion density, such as an inductive source power applicator consisting of inner and outer coil antennas overlying the wafer. Such an approach, however, can only address non-uniformities that are symmetrical, that is a center-high or a center-low etch rate distribution. In practice, non-uniformities in etch rate distribution can be non-symmetrical, such as a high etch rate in one corner of the mask, for example. A more fundamental limitation is that the mask etch process tends to have such an extremely center-low distribution of etch rate that a tunable feature, such an inductive power applicator having inner and outer coils, is incapable of transforming the etch rate distribution out of the center-low regime.

Another problem with non-uniform etch rate distribution is that the etch rate distribution tends to vary widely among different reactors of the same design and can vary widely within the same reactor whenever a key part or a consumable component is replaced, such as replacement of the cathode. The etch rate distribution appears to be highly sensitive to small variations in features of the replaced part, with unpredictable changes upon consumable replacement.
In light of the above, the plasma reactor according to independent claims 1, 3, 7, and 11 are provided.
Further advantages, features, aspects and details of the invention are evident from the dependent claims, the description and the drawings.

A plasma reactor is provided having multiple frequency control of etch parameters. The reactor includes a reactor chamber and a workpiece support within the chamber, the chamber having a ceiling facing the workpiece support. An inductively coupled plasma source power applicator overlies the ceiling, and an RF power generator is coupled to the inductively coupled source power applicator. A capacitively coupled plasma source power applicator comprises a source power electrode at the ceiling or the workpiece support. An array of passages extends through the workpiece support pedestal from a bottom thereof and forms an array of openings in a support surface of the workpiece support. An array of optical fibers extends through the passages, each fiber having: (a) a viewing end with a field of view through the opening in the support surface, and (b) an output end outside of the chamber. Optical sensors are coupled to the output ends of the optical fibers. The reactor further includes a controller responsive to the optical sensors for adjusting the relative amounts of power simultaneously coupled to plasma in the chamber by the inductively coupled plasma source power applicator and the capacitively coupled plasma source power applicator.
According to a further embodiment, a plasma reactor is,provided having multiple frequency control of etch parameters. The reactor includes a reactor chamber and a workpiece support within the chamber, the chamber having a ceiling facing the workpiece support, and an inductively coupled source power applicator and a capacitively coupled plasma source power applicator. An array of optical fibers extends through the support surface of the workpiece support to view the workpiece through its bottom surface. Optical sensors are coupled to the output ends of the optical fibers. The reactor further includes a controller responsive to the optical sensors for adjusting the relative amounts of power simultaneously coupled to plasma in the chamber by the inductively coupled plasma source power applicator and the capacitively coupled plasma source power applicator. According to some embodiments, which can be combined with other embodiments described herein, one or more optical sensors are coupled to the output ends of the optical fibers.

So that the manner in which the exemplary embodiments of the present invention are attained and can be understood in detail, a more particular description of the invention, briefly summarized above, may be had by reference to the embodiments thereof which are illustrated in the appended drawings. It is to be appreciated that certain well known processes are not discussed herein in order to not obscure the invention.

FIG. 1 depicts a plasma reactor for carrying out a mask etch process.

FIG. 2A depicts a lower portion of the reactor of FIG. 1.

FIG. 2B illustrates a mask support pedestal of the reactor of FIG. 1 in a raised position.

FIG. 3 is a top view of a cathode of the reactor of FIG. 1.

FIGS. 4 and 5 are top and side views of one alternative embodiment of the cathode.

FIGS. 6 and 7 are top and side views of another alternative embodiment of the cathode.

FIG. 8 is a simplified diagram of a plasma reactor having a backside end point detection apparatus.

FIGS. 9 and 10 are graphs of an optical end point detection signal obtained from the front side and back side, respectively, of the mask.

FIGS. 11 and 12 are graphs of an interference fringe optical signal obtained from the front side and back side, respectively, of the mask.

FIG. 13 is a graph of a multiple wavelength interference spectrum signal obtained in one embodiment of the reactor of FIG. 8.

FIG. 14 illustrates an embodiment of the reactor of FIG. 8 with backside end point detection based upon overall reflected light intensity, corresponding to FIG. 10.

FIG. 15 illustrates an embodiment of the reactor of FIG. 8 with backside endpoint detection based upon interference fringe counting, corresponding to FIG. 12.

FIG. 16 illustrates an embodiment of the reactor of FIG. 8 with backside endpoint detection based upon multiple wavelength interference spectrometry.

FIG. 17 illustrates an embodiment of the reactor of FIG. 8 with backside endpoint detection based upon optical emission spectrometry (OES).

FIG. 18 illustrates a working example having both OES and interference-based backside endpoint detection.

FIGS. 19 and 20 are perspective view of the cathode and facilities plate, respectively, of the embodiment of FIG. 18.

FIG. 21 is a cross-sectional view of the cathode of FIG. 19.

FIGS. 22A and 22B depict a sequence of steps in a quartz mask etch process employing backside endpoint detection.

FIGS. 23A, 23B, 23C, 23D and 23E depict a sequence of steps in a chrome-molysilicide-quartz mask etch process employing backside endpoint detection.

FIGS. 24A, 24B, 24C, 24D and 24E depict a sequence of steps in a chrome-quartz mask etch process employing backside endpoint detection.

FIGS. 25 and 26 are side and top views, respectively, of an embodiment in which real time etch rate distribution is continuously measured from the mask backside.

FIGS. 27 and 28 are perspective and top views, respectively, of an embodiment having an array of individually controllable gas injection nozzles.

FIG. 29 is a top view of an implementation of the embodiment of FIGS. 27 and 28 employing pneumatic valves.

FIGS. 30A through 30D are graphs of etch depth distribution across a mask obtained with different ones of the array of valves of FIGS. 27 and 28 being activated.

FIG. 31 depicts an alternative embodiment of the reactor of FIGS. 27 and 28.

FIG. 32 depicts another alternative embodiments of the reactor of FIGS. 27 and 28.

FIGS. 33 and 34 are a block diagram and a perspective view, respectively, of a plasma reactor capable of performing real-time feedback control of reactor tunable elements based upon instantaneous two-dimensional images of etch rate distribution.

FIG. 35 is a block diagram of a feedback control process that may be performed in the reactor of FIGS. 33 and 34.

FIG. 36 is a simplified block diagram of a plasma reactor in accordance with an embodiment of the invention.

FIGS. 37A and 37B together constitute a block diagram depicting a method of one embodiment of the invention, and these drawings are hereinafter referred to collectively as "FIG. 37".

FIG. 38A is a graph depicting a radial distribution of plasma ion density that is typical of an inductively coupled plasma.

FIG. 38B is a graph depicting the radial distribution of plasma ion density that is typical of a capacitively coupled plasma.

FIG. 38C is a graph depicting the radial distribution of plasma ion density obtained in the reactor of FIG. 36 in accordance with a method of the invention.

FIG. 39 illustrates ion radial distribution non-uniformity (deviation) as a function of the ratio of the power levels of inductively and capacitively coupled power.

FIG. 40 illustrates ion radial distribution non-uniformity (deviation) as a function of the ratio of the pulse duty cycles of inductively and capacitively coupled power.

FIG. 41 is a graph illustrating lines of constant plasma ion density for pairs of values of inductively and capacitively coupled power levels.

FIG. 42 is a graph illustrating lines of constant plasma ion density for pairs of values of inductively and capacitively coupled power pulsed duty cycles.

FIG. 43 is a graph illustrating the dependency of electron density in the bulk plasma as a function of source power levels for different VHF frequencies of the capacitively coupled power.

FIGS. 44A and 44B together constitute a block diagram depicting a method of another embodiment of the invention, and are hereinafter referred to collectively as "FIG. 44".

FIG. 45 is a graph illustrating different bulk plasma electron energy distribution functions obtained for different mixtures of capacitively and inductively coupled power.

FIG. 46 depicts the change in electron energy distribution functions for different source power levels obtained when capacitively coupled power is added to inductively coupled power.

FIG. 47 depicts different optical emission spectra obtained for different degrees of dissociation (electron energy distributions).

FIG. 48 is a graph depicting how the degree of dissociation (e.g., population of free carbon or free fluorine) increases with increasing ratio of inductively coupled power to capacitively coupled power.

FIG. 49 is a graph depicting how the degree of dissociation (e.g., population of free carbon or free fluorine) increases with increasing ratio of inductively coupled power pulsed duty cycle to capacitively coupled power duty cycle.

FIGS. 50A and 50B illustrate the contemporaneous waveforms of pulsed inductively coupled power and capacitively coupled power, respectively.

FIG. 51 is a graph illustrating how the degree of dissociation decreases with increasing frequency of capacitively coupled power.

FIGS. 52A, 52B and 52C are graphs of sheath ion energy distribution for the cases in which only low frequency bias power is applied, only high frequency bias power is applied and both low and high frequency bias power is applied to the wafer, respectively.

FIG. 53 illustrates a multi-layer gate structure which is to be etched in the process of FIG. 37 or FIG. 44.

FIG. 54 illustrates a plasma reactor in accordance with a first embodiment.

FIGS. 55 and 56 illustrate different implementations of a ceiling electrode in the reactor of FIG. 54.

FIGS. 57 and 58 illustrate different embodiments of the inductive antenna of the reactor of FIG. 54.

FIG. 59 illustrates a plasma reactor in accordance with another embodiment.

FIG. 60 illustrates a plasma reactor in accordance with yet another embodiment.

FIG. 61 illustrates a plasma reactor in accordance with a further embodiment.

FIG. 62 illustrates a plasma reactor in accordance with a yet further embodiment.

FIG. 63 illustrates a plasma reactor in accordance with another embodiment.

To facilitate understanding, identical reference numerals have been used, where possible, to designate identical elements that are common to the figures. It is contemplated that elements and features of one embodiment may be beneficially incorporated in other embodiments without further recitation. It is to be noted, however, that the appended drawings illustrate only exemplary embodiments of this invention and are therefore not to be considered limiting of its scope, for the invention may admit to other equally effective embodiments.

### Cathode with Enhanced RF Uniformity:

We have discovered that one source of non-uniform etch rate distribution in mask etch processes is the existence of RF electrical non-uniformities in the support pedestal or cathode holding the mask in the plasma reactor in which the mask etch process is carried out. RF bias power is applied to the pedestal to control plasma ion energy at the mask surface, while RF source power is applied to an overhead coil antenna, for example, to generate plasma ions. The RF bias power controls the electric field at the mask surface that affects the ion energy. Since the ion energy at the mask surface affects the etch rate, RF electrical non-uniformities in the pedestal create non-uniformities in the distribution of etch rate across the mask surface. We have discovered that there are several sources of RF non-uniformity in the pedestal. One is the titanium screws that fasten the aluminum pedestal (cathode) and aluminum facilities plate together. The screws create nodes in the electric field pattern across the surface of the pedestal (and therefore across the surface of the mask because their electrical properties differ from that of the aluminum cathode. Another is the non-uniform distribution of conductivity between the cathode and the facilities plate. Electrical conduction between the facilities plate and the cathode is confined primarily to the perimeter of the plate and cathode. This can be due at least in part to bowing of the cathode during plasma processing induced by vacuum pressure. The conduction around this perimeter can be non-uniform due to a number of factors, such as uneven tightening of the titanium screws and/or surface finish variations around the perimeter of either the plate or the pedestal. We have solved these problems by the introduction of several features that enhance RF electrical uniformity across the pedestal. First, the non-uniformities or discontinuities in the RF field arising from the presence of the titanium screws in the aluminum cathode are addressed by providing a continuous titanium ring extending around the perimeter of the top surface of the cathode that encompasses the heads of all the titanium screws. Variations in conductivity due surface differences or uneven tightening of the titanium screws are addressed by providing highly conductive nickel plating on the facing perimeter surfaces of the facilities plate and the cathode, and by the introduction of an RF gasket between the facilities plate and the cathode that is compressed between them at their perimeter.

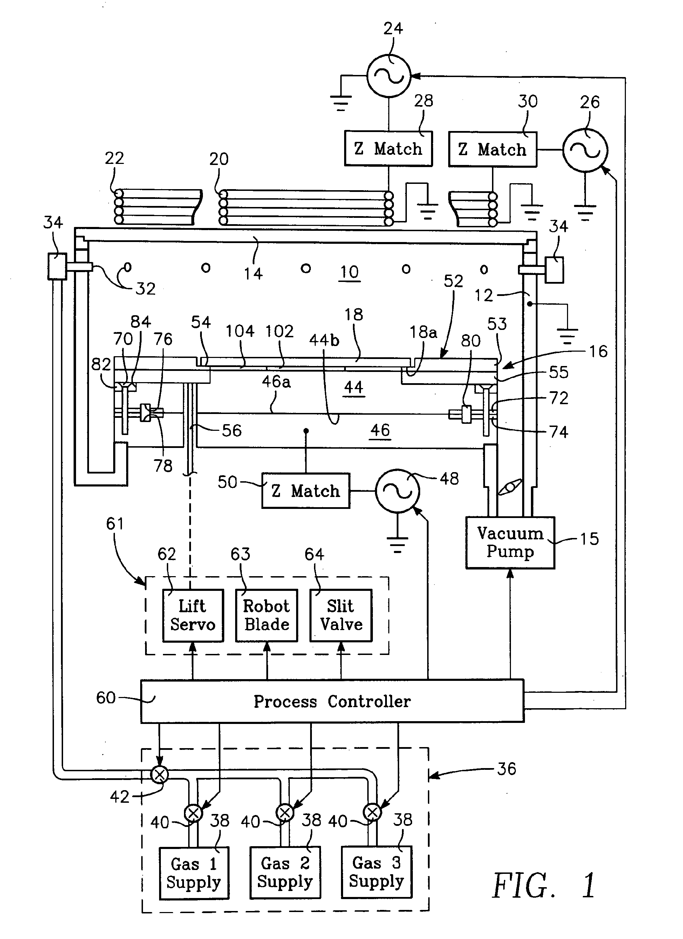

Referring to FIG. 1, a plasma reactor for etching patterns in a mask includes a vacuum chamber 10 enclosed by a side wall 12 and an overlying ceiling 14 and is evacuated by a vacuum pump 15 that controls chamber pressure. A mask support pedestal 16 inside the chamber 10 supports a mask 18. As will be described later in this specification, the mask typically consists of a quartz substrate and can further include additional mask thin film layers on the top surface of the quartz substrate, such as chrome and molybdenum silicide. In addition, a pattern-defining layer is present, which may be photoresist or a hardmask formed of the chrome layer. In other types of masks, the quartz substrate has no overlying layers except for the photoresist pattern.

Plasma source power is applied by overlying inner and outer coil antennas 20, 22 driven by respective RF source power generators 24, 26 through respective RF impedance match circuits 28, 30. While the sidewall 12 may be aluminum or other metal coupled to ground, the ceiling 14 is typically an insulating material that permits inductive coupling of RF power from the coil antennas 20, 22 into the chamber 10. Process gas is introduced through evenly spaced injection nozzles 32 in the top of the side wall 12 through a gas manifold 34 from a gas panel 36. The gas panel 36 may consist of different gas supplies 38 coupled through respective valves or mass flow controllers 40 to an output valve or mass flow controller 42 coupled to the manifold 34.

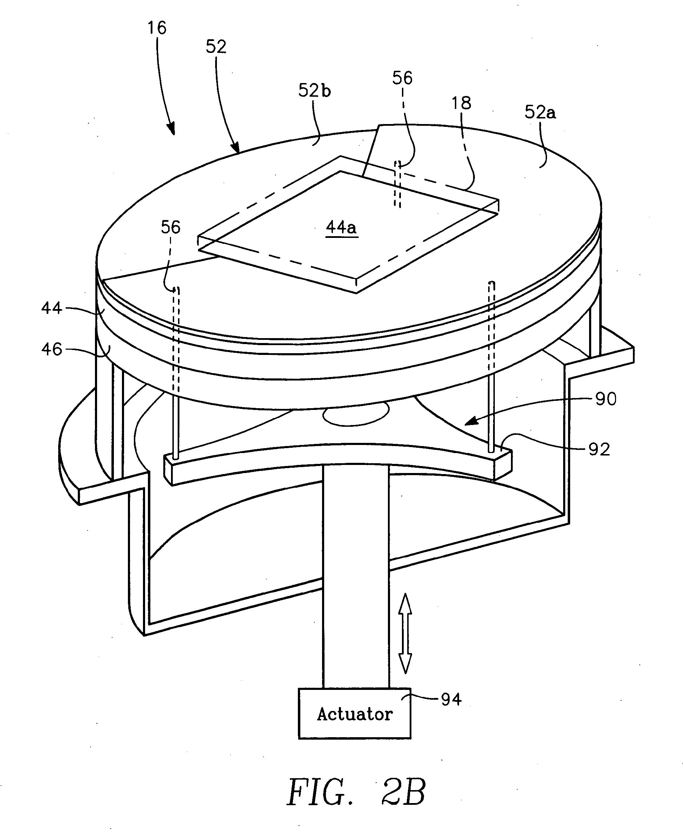

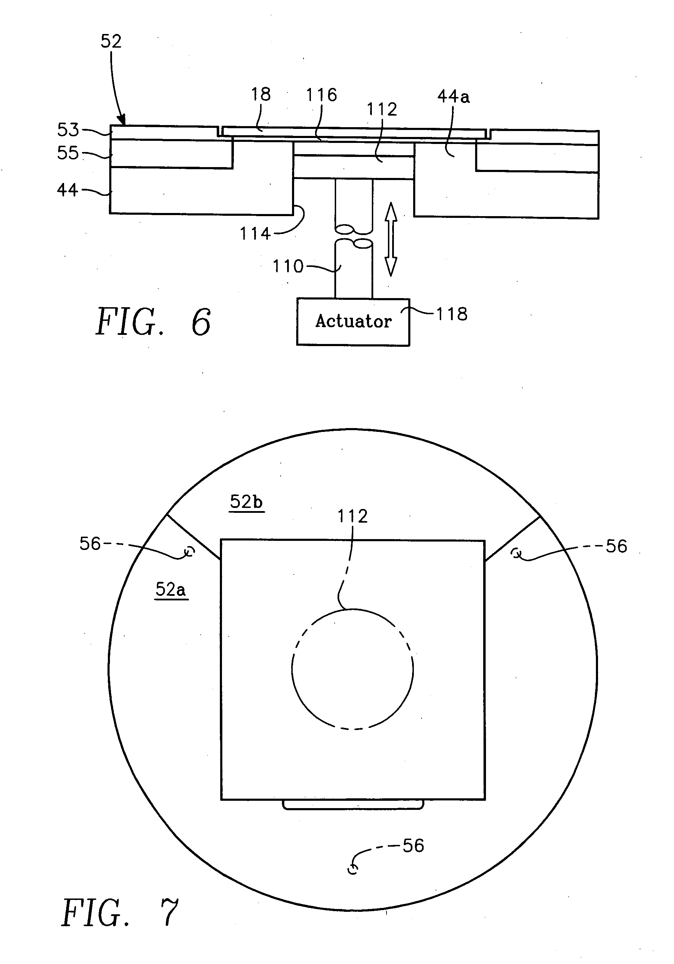

The mask support pedestal 16 consists of a metal (e.g., aluminum) cathode 44 supported on a metal (e.g., aluminum) facilities plate 46. The cathode 44 has internal coolant or heating fluid flow passages (not shown) that are fed and evacuated by supply and drain ports (not shown) in the facilities plate 46. RF bias power is applied to the facilities plate by an RF bias power generator 48 through an RF impedance match circuit 50. The RF bias power is conducted across the interface between the facilities plate 46 and the cathode 44 to the top surface of the cathode 44. The cathode 44 has a central plateau 44a upon which the square quartz mask or substrate 18 is supported. The plateau dimensions generally match the dimensions of the mask 18, although the plateau 44a is slightly smaller so that a small portion or lip 18a of the mask perimeter extends a short distance beyond the plateau 44a, as will be discussed below. A pedestal ring 52 surrounding the plateau 44a is divided (in wedge or pie section fashion as shown in FIG. 2B or FIG. 7) into a cover ring 52a forming about two-fifths of the ring 52 and a capture ring 52b forming the remaining three-fifths of the ring 52. The capture ring 52b has a shelf 54 in which the lip 18a of the mask 18 rests. Three lifts pins 56 (only one of which is visible in the view of FIG. 1) lift the capture ring 52b, which raises the mask 18 by the lip 18a whenever it is desired to remove the mask 18 from the support pedestal 16. The pedestal ring 52 consists of layers 53, 55 of materials of different electrical characteristics selected to match the RF impedance presented by the combination of the quartz mask 18 and the aluminum plateau 44a, at the frequency of the bias power generator 48. (Both the cover and capture rings 52a, 52b consist of the different layers 53, 55.) Moreover, the top surface of the capture ring 52 is coplanar with the top surface of the mask 18, so that a large uniform surface extending beyond the edge of the mask 18 promotes a uniform electric field and sheath voltage across the surface of the mask 18 during plasma processing. Typically, these conditions are met if the lower ring layer 55 is quartz and the upper ring layer 53 is a ceramic such as alumina. A process controller 60 controls the gas panel 36, the RF generators 24, 26, 48, and wafer handling apparatus 61. The wafer handing apparatus can include a lift servo 62 coupled to the lift pins 56, a robot blade arm 63 and a slit valve 64 in the side wall 12 of the chamber 10.

A series of evenly spaced titanium screws 70 fasten the cathode 44 and facilities plate 46 together along their perimeters. Because of the electrical dissimilarities between the aluminum cathode/facilities plate 44, 46 and the titanium screws 70, the screws 70 introduce discrete non-uniformities into the RF electrical field at the top surface of the cathode 44. Variations in the opposing surfaces of the cathode 44 and facilities plate 46 create non-uniformities in the conductivity between the cathode 44 and facilities plate 46 along their perimeter, which introduces corresponding non-uniformities in the RF electrical field. Because the cathode 44 tends to bow up at its center during plasma processing (due to the chamber vacuum), the principal electrical contact between the cathode 44 and the facilities plate 46 is along their perimeters. In order to reduce the sensitivity of the electrical conductivity between the cathode 44 and facilities plate 46 to (a) variations in tightness among the various titanium screws 70 and (b) variations in surface characteristics, an annular thin film 72 of a highly conductive material such as nickel is deposited on the perimeter of the bottom surface 44b of the cathode 44, while a matching annular thin film 74 of nickel (for example) is deposited on the perimeter of the top surface 46a of the facilities plate 46. The nickel films 72, 74 are in mutual alignment, so that the two annular nickel thin films 72, 74 constitute the opposing contacting surfaces of the pedestal 44 and facilities plate 46, providing a highly uniform distribution of electrical conductivity between them. Further improvement in uniform electrical conductivity is realized by providing an annular groove 76 along the perimeter of the bottom surface of the cathode 44 and placing a conductive RF gasket 80 within the groove 76. Optionally, a similar annular groove 78 in the top surface of the facilities plate 46 may be provided that is aligned with the groove 76. The RF gasket 80 may be of a suitable conventional variety, such as a thin metal helix that is compressed as the cathode 44 and facilities plate 46 are pressed together and the screws 70 tightened. In order to reduce or eliminate the point non-uniformities in electrical field distribution tending to occur at the heads of the titanium screws 70, a continuous titanium ring 82 is placed in an annular groove 84 in the perimeter of the top surface of the cathode 44.

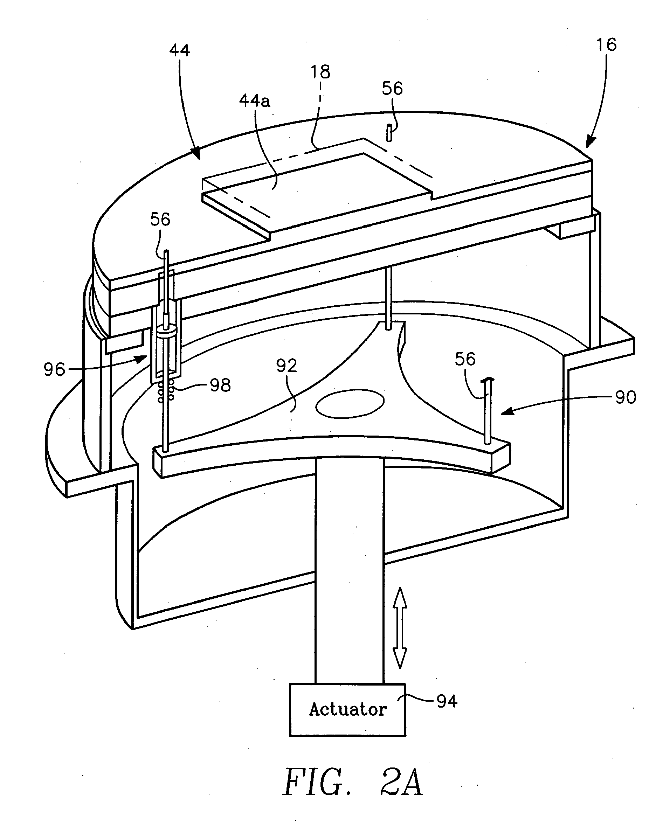

FIG. 2A depicts the mask support pedestal 16 and its underlying lift assembly 90. The lift assembly 90 includes a lift spider 92 driven by a pneumatic actuator or lift servo 94 and the three lift pins 56 resting on the lift spider 92. The lift pins 56 are guided in lift bellows 96 that include ball bearings 98 for extremely smooth and nearly frictionless motion (to reduce contamination arising from wear). FIG. 2B depicts the cathode 44 with the capture ring 52b and mask 18 in the raised position. The void formed by separation of the cover and capture rings 52a, 52b when the mask is raised permits access by a robot blade to the mask 18.

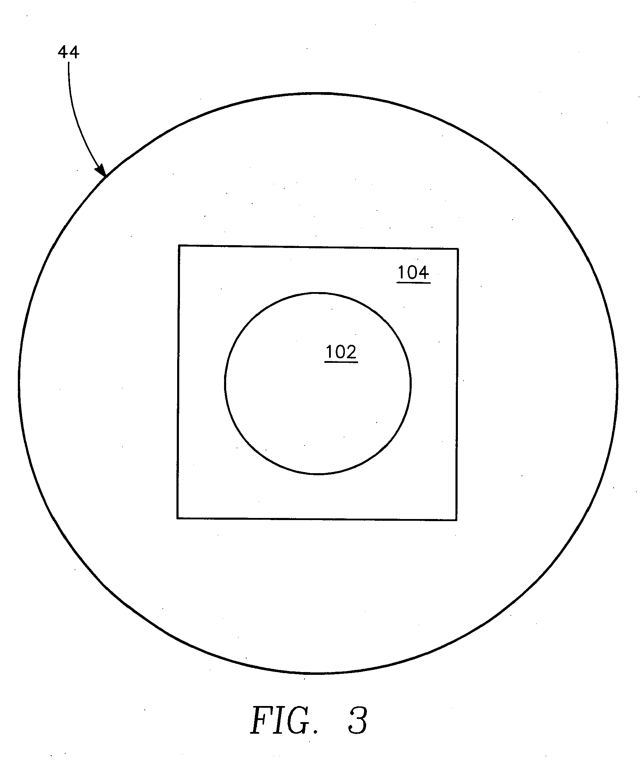

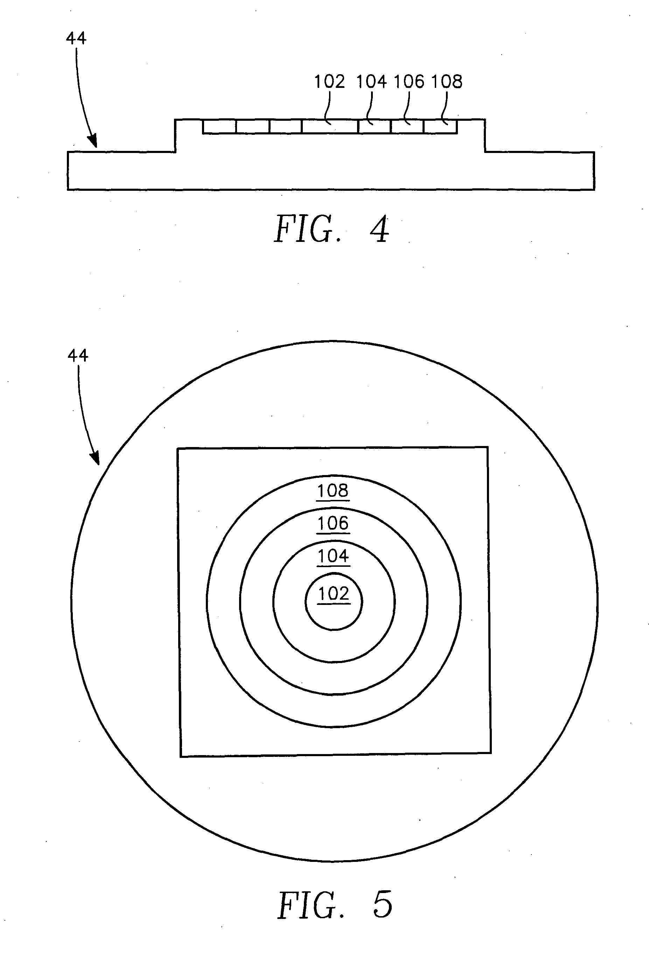

The problem of an extremely center-low etch rate distribution across the surface of the mask 18 is solved by altering the distribution of the electrical properties (e.g., electrical permittivity) of the cathode plateau 44a. This is achieved in one embodiment by providing, on the top surface of the plateau 44a, a center insert 102 and a surrounding outer insert 104, the two inserts forming a continuous planar surface with the pedestal ring 52 and being of electrically different materials. For example, in order to reduce the tendency of the etch rate distribution to be extremely center-low, the center insert 102 may be of a conductive material (e.g., aluminum) while the outer insert 104 may be of an insulating material (e.g., a ceramic such as alumina). This conductive version of the center insert 102 provides a much lower impedance path for the RF current, boosting the ion energy and etch rate at the center of the mask 18, while the insulating outer insert 104 presents a higher impedance, which reduces the etch rate at the periphery of the mask 18. This combination improves the etch rate distribution, rendering it more nearly uniform. With this feature, fine tuning of the etch rate distribution can be performed by adjusting the relative RF power levels applied to the inner and outer coil antennas 20, 22. The change in radial distribution of plasma ion density required to achieve uniform etch rate distribution is reduced to a much smaller amount which is within the capability of RF power apportionment between the inner and outer coils 20, 22 to attain uniform etch rate distribution. FIG. 3 is a top view of the inner and outer inserts 102, 104. In an alternative embodiment, the inserts 102, 104 may be insulators having different dielectric constants (electrical permittivities). FIGS. 4 and 5 depict an elaboration upon this concept, in which four concentric rings 102, 104, 106, 108 of progressively different electrical properties are employed to render the etch rate distribution more uniform. FIGS. 6 and 7 depict an alternative embodiment that provides real-time tunability of distribution of RF electrical properties of the cathode 44. A plunger 110 controls the axial position of a movable aluminum plate 112 within a hollow cylinder 114 in the center interior of the cathode 44. The aluminum plate 112 is in electrical contact with the remainder of the aluminum plateau 44a. An insulator (e.g., ceramic) top film 116 can cover the top of the cathode 44. As the aluminum plate 112 is pushed closer to the top of the cylinder 114, the electrical impedance through the center region of the cathode 44 is reduced, thereby raising the etch rate at the center of the mask 18. Conversely, the etch rate at the mask center is reduced as the aluminum plate 112 is moved downward in the cylinder 114 away from the mask 18. An actuator 118 controlling axial movement of the plunger 110 can be governed by the process controller 60 (FIG. 1) to adjust the etch rate distribution to maximize uniformity or compensate for non-uniformities.

### Etch Rate Monitoring and End Point Detection Through the Mask Backside:

The high production cost of periodic interruptions of the etch process to measure the etch depth or critical dimension on the mask is reduced or eliminated using optical sensing through the cathode 44 and through the backside of the mask or substrate 18. It has been necessary to interrupt the etch process to perform such periodic measurements because of the poor etch selectivity relative to photoresist: in general, the mask materials etch more slowly than the photoresist. This problem is typically addressed by depositing a thick layer of photoresist on the mask, but the high rate of etching of the resist renders the photoresist surface randomly uneven or rough. This roughness affects light passing through the photoresist and so introduces noise into any optical measurement of critical dimension or etch depth. Therefore, the photoresist is temporarily removed for each periodic measurement to ensure noise-free optical measurements, necessitating re-deposition of photoresist and re-writing of the reticle pattern into the photoresist before re-starting the interrupted mask etch process.

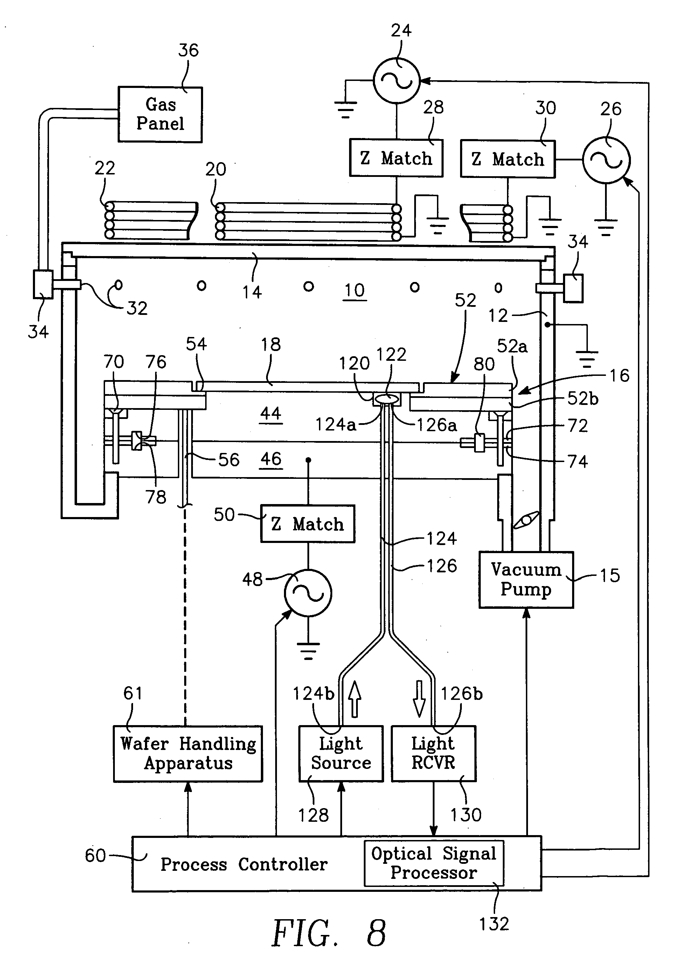

The mask etch plasma reactor depicted in FIG. 8 avoids these difficulties and permits continuous observation of critical dimensions or measurement of etch depth during the entire etch process while the mask or substrate 18 is left in place on the mask support pedestal 16 using backside optical measurement apparatus provided within the cathode 44. The backside measurement apparatus takes advantage of the optically transparent nature of the mask substrate 18, which is typically quartz. The thin films that may be deposited over it (such as chrome or molybdenum silicide) may be opaque, but the formation of patterned openings defining the reticle pattern of the mask 18 can be sensed optically. The change in light intensity reflected by such layers or transmitted through such layers may be observed at the mask back side through the cathode 44. This observation may be used to perform etch process end point detection. When etching the quartz material, optical interference observed at the mask back side through the cathode 44 may be sensed to perform etch depth measurements in real time during the etch process. One advantage is that the images or light signals sensed from the mask backside are not affected by photoresist noise, or at least are affected very little compared with attempts to perform such measurements from the top surface (photoresist side) of the mask 18.

For these purposes, the reactor of FIG. 8 includes a recess 120 within the top surface of the cathode 44 that accommodates a lens 122 whose optical axis faces the backside of the mask or substrate 18. A pair of optical fibers 124, 126, whose diameters are small relative to the lens 122, have ends 124a, 126a close to or contacting the lens 122 and both are aligned next to each other at the optical axis of the lens 122. Each of the optical fibers 124, 126 depicted in FIG. 8 may actually be a small bundle of optical fibers. The optical fiber 124 has its other end 124b coupled to a light source 128. The light source emits light of a wavelength at which the mask 18 is transparent, typically visible wavelengths for a quartz mask. In the case of interference depth measurements, the wavelength spectrum of the light source 128 is selected to facilitate local coherence in the reticle pattern of the mask 18. For periodic features in the etched mask structure on the order of about 45 nm (or periodic feature sizes below one micron), this requirement is met if the light source 128 radiates in the visible light spectrum. The optical fiber 126 has its other end 126b coupled to a light receiver 130. In the case of simple end point detection, the light receiver 130 may simply detect light intensity. In the case of critical dimension (e.g., line width) measurements, the light receiver 130 may sense the image of etched lines within the field of view of the lens 122, from which the line width can be determined. In the case of etch depth measurements, the light receiver 130 may detect an interference pattern or interference fringes, from which the etch depth may be determined (i.e., inferred from the interference or diffraction pattern or computed from the counting of interference fringes). In other embodiments, the light receiver 130 may include a spectrometer for performing multiple wavelength interference measurements, from which etch depth may be inferred or computed. For such determinations, the process controller 60 includes an optical signal processor 132 capable of processing the optical signal from the light receiver. Such optical signal processing may involve (depending upon the particular implementation) one of the following: performing etch process end point detection from ambient light intensity changes; measuring critical dimensions from two-dimensional images sensed by the optical receiver 130; computing etch depth by counting interference fringes; determining etch depth from the multiple wavelength interference spectrum, in which case the optical receiver 130 consists of a spectrometer. Alternatively, such a spectrometer may be employed to perform etch process end point detection by optical emission spectrometry from the wafer backside, using light emitted by the plasma and transmitted through the transparent mask 18, in which case the light source 128 is not employed.

The process controller 60 reacts to the process end point detection information (or the etch depth measurement information) from the optical signal processor 132 to control various elements of the plasma reactor, including the RF generators 24, 26, 48 and the wafer-handling apparatus 61. Typically, the process controller 60 stops the etch process and causes removal the mask 18 from the pedestal 16 when the etch process end point is reached.

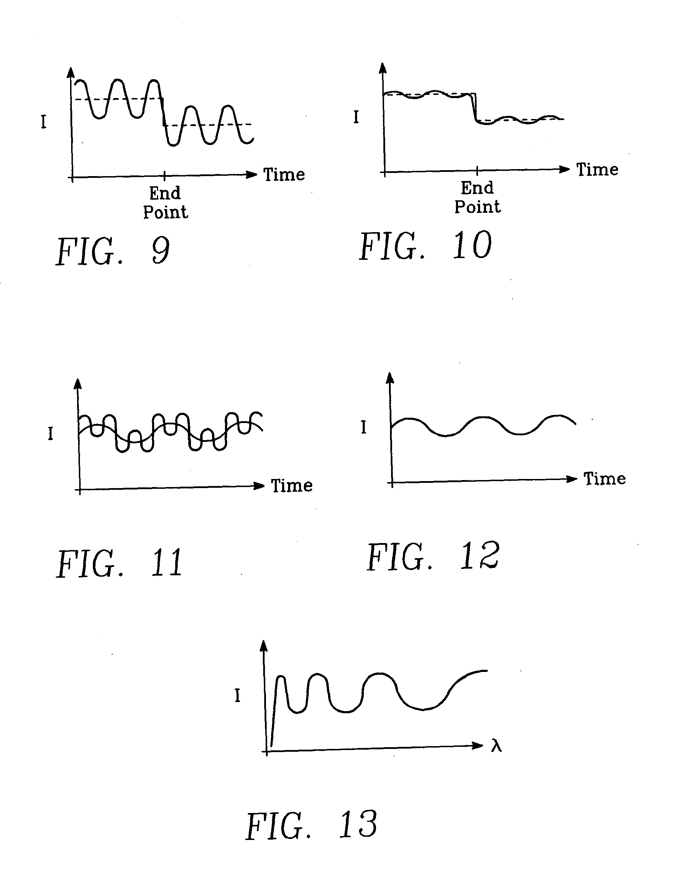

FIG. 9 is a graph depicting ambient reflected light intensity sensed from the top (photoresist-coated) side of the mask as a function of time during a chrome etch process (in which a chrome thin film on the quartz mask surface is etched in accordance with a mask reticle pattern). The large swings in intensity depicted in the graph of FIG. 9 represent noise induced by roughness in the top surface of the photoresist layer. The dashed line represents a step function signal hidden within the noise, the step function coinciding with the chrome etch process end point. FIG. 10 is a graph of the same measurement taken from the wafer backside through the cathode 44 in the reactor of FIG. 8, in which the light receiver 130 senses the reflected light level. The photoresist-induced noise is greatly reduced, so that the end-point defining step function is clearly represented in the optical data. The edge of the step function depicts a transition point at which reflected light intensity drops upon the etch process reaching the bottom of the chrome thin film, at which point the reflective surface area of the chrome is abruptly reduced.

FIGS. 11 and 12 are graphs of light intensity over time (or, equivalently, over space), and, in FIG. 12, as sensed by the optical receiver 130, in which the periodic peaks in light intensity correspond to interference fringes whose spacing determines the etch depth, or difference in thickness between different surfaces of closely periodically spaced features etched in the transparent quartz mask substrate 18. FIG. 11 depicts the intensity sensed through the photoresist from the top side of the mask, with a heavy photoresist-induced noise component that impairs interference fringe detection. FIG. 12 depicts the intensity sensed through the mask backside by the optical receiver 130 of FIG. 8, in which photoresist-induced noise is virtually absent.

FIG. 13 is a graph representing light intensity as a function of wavelength for the case in which the light receiver 130 consists of a spectrometer and the light source 128 produces a spectrum of wavelengths. The behavior of the intensity spectrum of the graph of FIG. 13 is typical of a situation in which interference effects occur between light reflected from surfaces of different depths in sub-micron features that are periodically spaced in the transparent mask 18. At the lower wavelengths, the peaks are fairly periodic and even spaced, the predominant optical effect being interference. At the higher wavelengths, local coherence among the periodic features in the mask 18 is not as strong, so that diffraction effects become increasingly significant with increasing wavelength, causing the intensity behavior at the higher wavelengths to be less evenly spaced and more complex, as depicted in FIG. 13. The spacing of the peaks in FIG. 13, particularly at the lower wavelengths, is a function of the etch depth, which may be inferred from the peak-to-peak spacing.

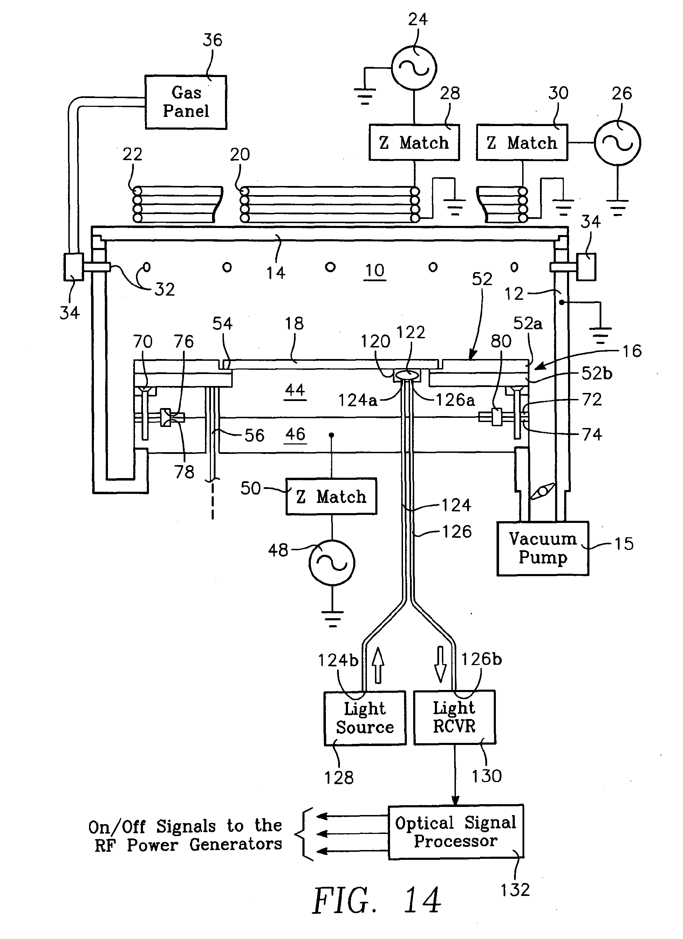

FIG. 14 illustrates an embodiment of the reactor of FIG. 8, in which the light receiver 130 is an ambient light intensity detector and the optical signal processor 132 is programmed to look for a large inflection (step function) in the overall reflected light intensity, corresponding to the end point detection graph of FIG. 10. The light source 128 in this embodiment can be any suitable light source. Alternatively, the light source 128 can be eliminated, so that the light sensor 130 simply responds to light from the plasma transmitted through the transparent mask or substrate 18.

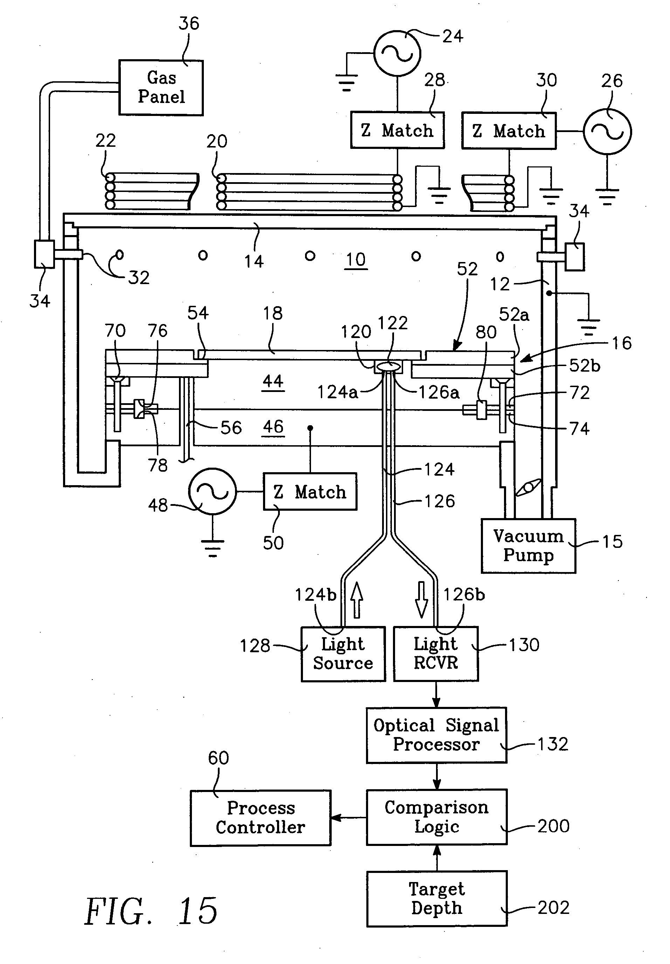

FIG. 15 illustrates an embodiment of the reactor of FIG. 8 in which the light receiver 130 is an interference fringe detector sufficiently focused by the lens 122 to resolve interference fringes, and the optical signal processor 132 is programmed to count interference fringes (e.g., from intensity versus time data of the type illustrated in FIG. 12) in order to compute etch depth in the transparent quartz mask 18. This computation yields a virtually instantaneous etch depth, which is compared by logic 200 with a user-defined target depth stored in a memory 202. The logic 200 can use a conventional numerical match or minimization routine to detect a match between the stored and measured depth values. A match causes the logic 200 to flag the etch end point to the process controller 60.

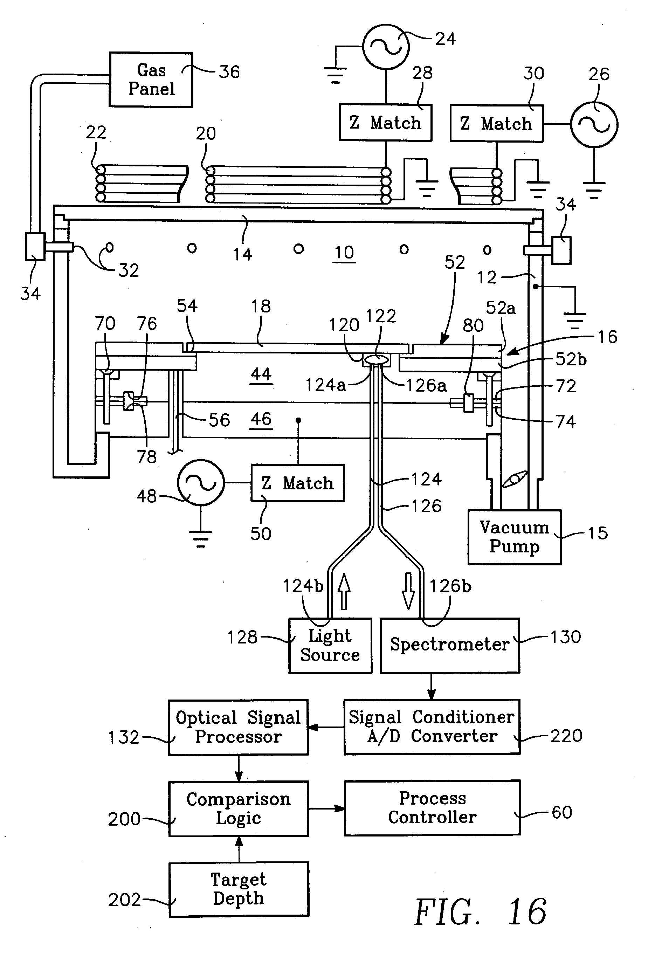

FIG. 16 illustrates an embodiment of the reactor of FIG. 8 which employs the interference spectroscopy technique of FIG. 13 to measure or determine etch depth in the transparent quartz mask or substrate 18. In this case, the light source 128 emits multiple wavelengths or a spectrum in the visible range (for periodic mask feature sizes on the order of hundreds of nanometers or less). The light receiver 130 is a spectrometer. A combination signal conditioner and analog-to-digital converter 220 converts the spectrum information collected by the spectrometer 130 (corresponding to the graph of FIG. 13) into digital data which the optical signal processor 132 can handle. One mode in which end point detection can be performed is to compute the etch depth from the spacing between the periodic peaks in the lower wavelength range of the data represented by FIG. 13, as mentioned above. Comparison logic 200 can compare the instantaneous measured etch depth to a user-defined target depth stored in memory 202 to determine whether the etch process end point has been reached. In another mode, the comparison logic 200 is sufficiently robust to compare the digitally represented wavelength spectrum (corresponding to the graph of FIG. 13) representing the instantaneous output of the spectrometer 130 with a known spectrum corresponding with the desired etch depth. This known spectrum may be stored in the memory 202. A match between the measured spectrum and the stored spectrum, or an approximate match, detected by the comparison logic 200 results in an etch process end point flag being sent to the process controller 60.

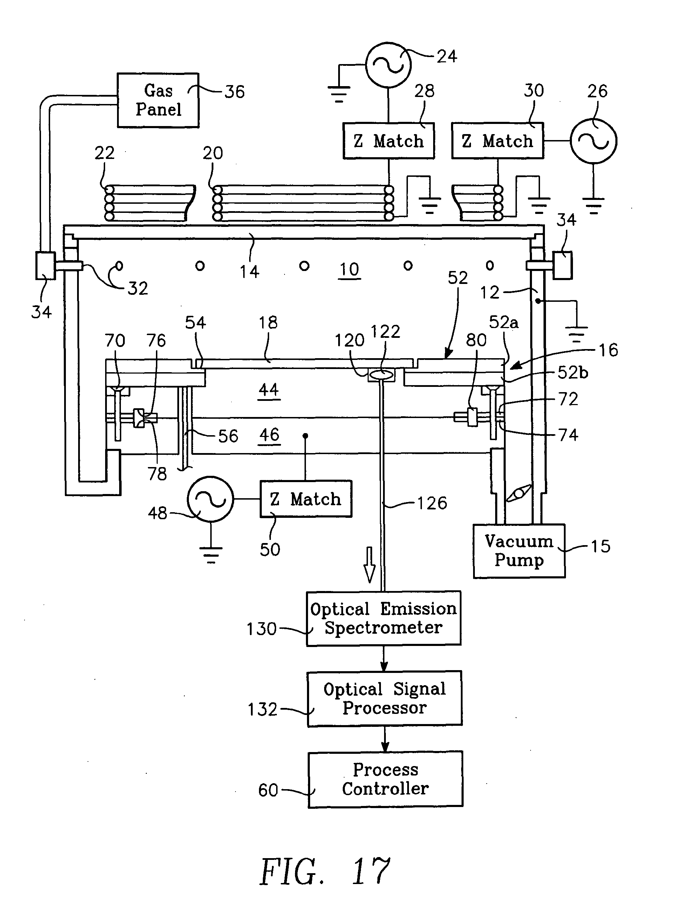

FIG. 17 illustrates an embodiment of the reactor of FIG. 8 in which the optical receiver 130 is an optical emission spectrometer capable of differentiating emission lines from optical radiation emitted by the plasma in the chamber, to perform optical emission spectrometry (OES). The processor 132 is an OES processor that is programmed to track the strength (or detect the disappearance) of selected optical lines corresponding to chemical species indicative of the material in the layer being etched. Upon the predetermined transition (e.g., the disappearance of a chrome wavelength line in the OES spectrum during a chrome etch process), the processor 132 sends an etch process end point detection flag to the process controller 60.

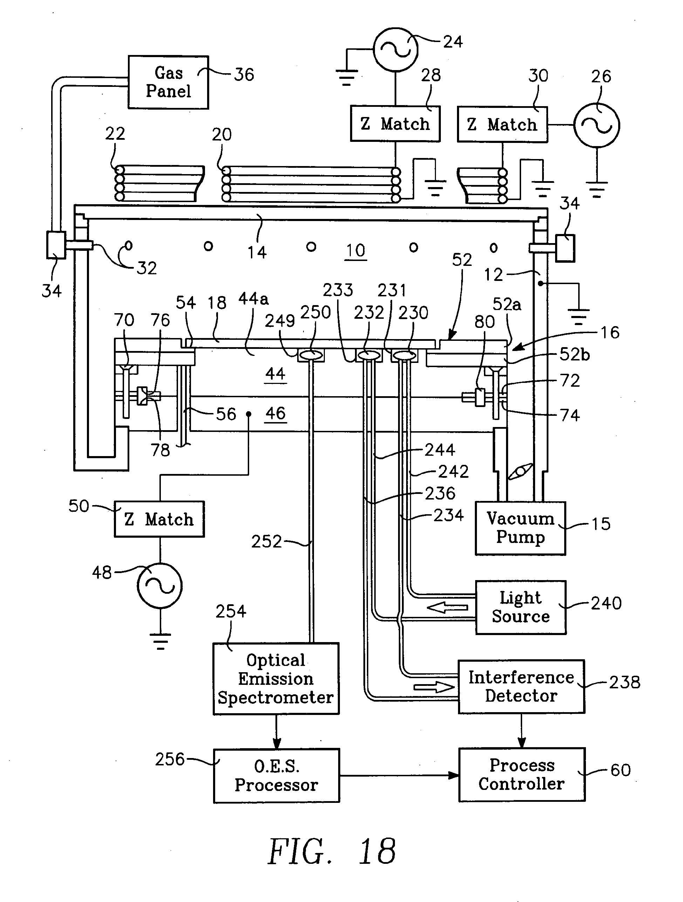

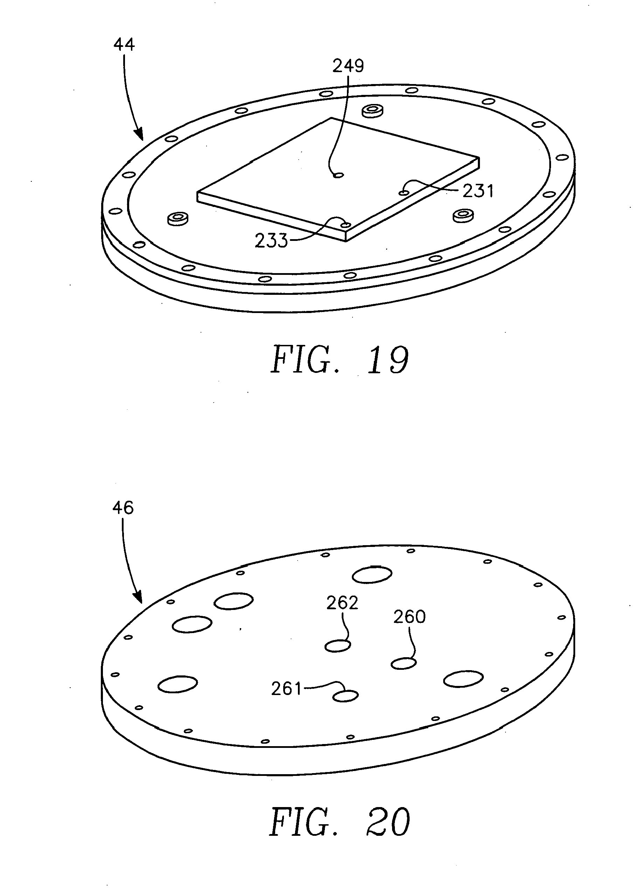

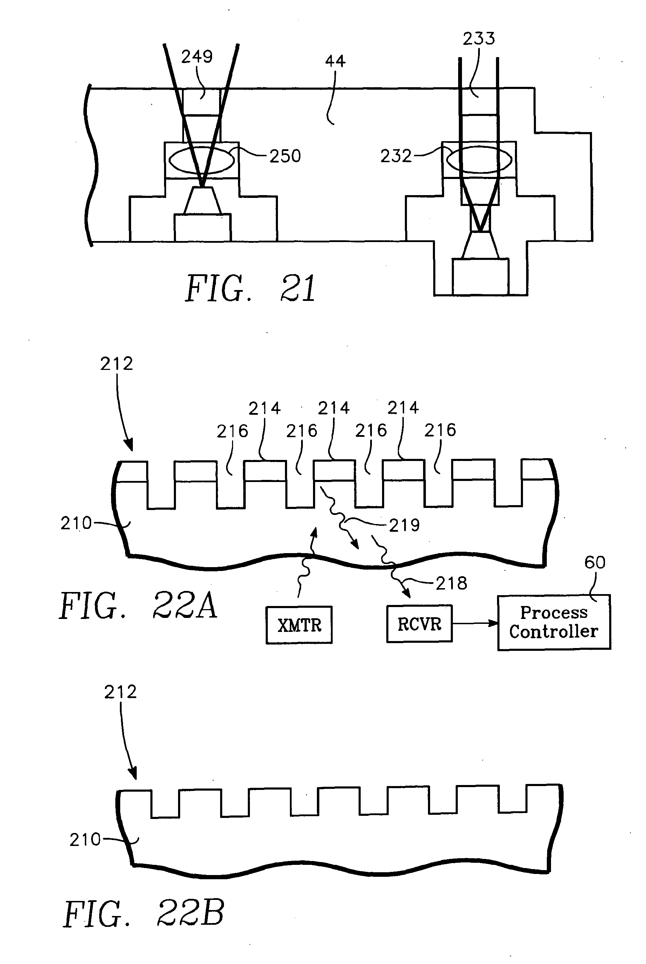

FIG. 18 depicts an embodiment that we have constructed, having a pair of lenses 230, 232 in respective spaced recesses 231, 233 in the surface of the cathode 44, the lenses 230, 232 being focused to resolve interference fringes, the focused light being carried by respective optical fibers 234, 236 facing or contacting the respective lenses 230, 232. The optical fibers 234, 236 are coupled to an interference detector 238 (which may be either a fringe detector or a spectrometer), the detector 238 having an output coupled to the process controller 60. The lenses 230, 232 receive light from a light source 240 through optical fibers 242, 244. This light is reflected from the top surface of the mask 18 back to the lenses 230, 232 and carried by the optical fibers 234, 236 to the detector 238. In addition, the embodiment of FIG. 18 has a third recess 249 in the cathode surface accommodating a third lens 250 coupled through an optical fiber 252 to the input of an OES spectrometer 254. An OES processor 256 processes the output of the OES spectrometer 254 to perform end point detection, and transmits the results to the process controller 60. The cathode 44 of the embodiment of FIG. 18 is depicted in FIG. 19, showing the three recesses 231, 233, 249 accommodating the respective lenses 230, 232, 250. FIG. 20 illustrates the corresponding holes 260, 261, 262 for accommodating within the facilities plate 46 optical apparatus (not shown) supporting the lenses 230, 232, 250. FIG. 21 is a cross-sectional view showing the coupling of the optical fibers to the lenses inside the pedestal 16.

While the reactors of FIGS. 16, 17 and 18 have been described as employing spectrometers 130 (FIGS. 16 and 17) and 254 (FIG. 18), the spectrometer 130 or 254 may be replaced by one or more optical wavelength filters tuned to predetermined wavelengths. Each such optical wavelength filter may be combined with a photomultiplier to enhance the signal amplitude.

### Backside End Point-Detected Mask Etch Processes:

FIGS. 22A and 22B depict a process for etching a reticle pattern in the quartz material of a mask. In FIG. 22A, a quartz mask substrate 210 has been covered with a photoresist layer 212 having a periodic structure of spaced lines 214 and openings 216 defined in the photoresist layer 212. In the reactor of FIG. 15 or 16, a quartz-etching process gas of CHF3 + CF4 + Ar is introduced into the chamber 10, power is applied by the RF generators 24, 26 and 48 and the quartz material is etched within the openings 216 formed in the photoresist layer 212. The etch depth in the quartz is continually measured by interference between light 218 reflected from an etched top surface and light 219 reflected from an unetched top surfaces of the quartz substrate 210. The etch process is halted as soon as the desired etch depth is reached (FIG. 22A). The photoresist is then removed to produce the desired mask (FIG. 22B).

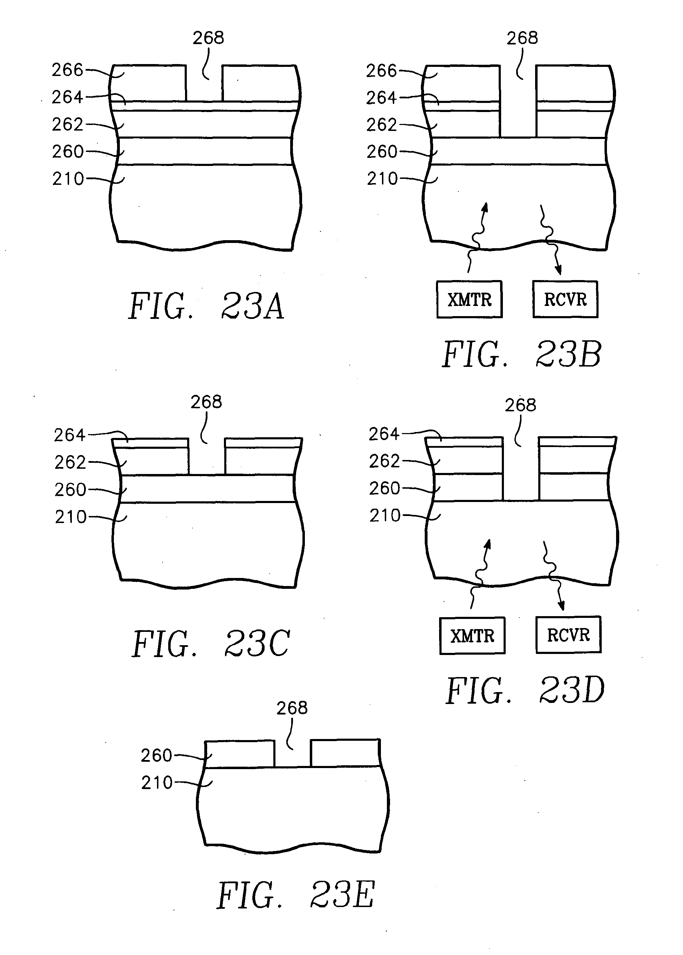

FIGS. 23A through 23E depict a process for etching a three-layer mask structure consisting of the underlying quartz mask substrate 210, a molybdenum silicide layer 260, (containing molybdenum oxy-silicon nitride), a chrome layer 262, a chromium oxide anti-reflective coating 264 and a photoresist layer 266, with openings 268 formed in the photoresist layer 266 (FIG. 23A). In the step of FIG. 23B, the chrome layer 262 and the anti-reflection coating 264 are etched in a plasma reactor chamber having simple reflectance end point detection (the chamber of FIG. 14) or having OES end point detection (the chamber of FIG. 17) using a chrome etch process gas such as C12 + 02 + CF4. The photoresist layer 266 is removed (FIG. 23C). The molybdenum silicide layer 260 is then etched as shown in FIG. 23D, using a process gas which is an etchant of molybdenum silicide, such as SF6 + C12, and using the chrome layer 262 as a hard mask. This step is carried out in a plasma reactor having end point detection by simple ambient reflectance or by OES end point detection, such as the chamber of FIG. 14 or FIG. 17. In FIG. 23E, the chrome layer 262 and the chromium oxide anti-reflection coating 264 are removed using a chrome etching process gas such as CH3+CF4+Ar. This step can be carried out using the reactor of FIG. 14 or 17 having simple end point detection without etch depth measurement. This leaves a quartz mask substrate with an overlying layer of molybdenum silicide defining the reticle pattern.

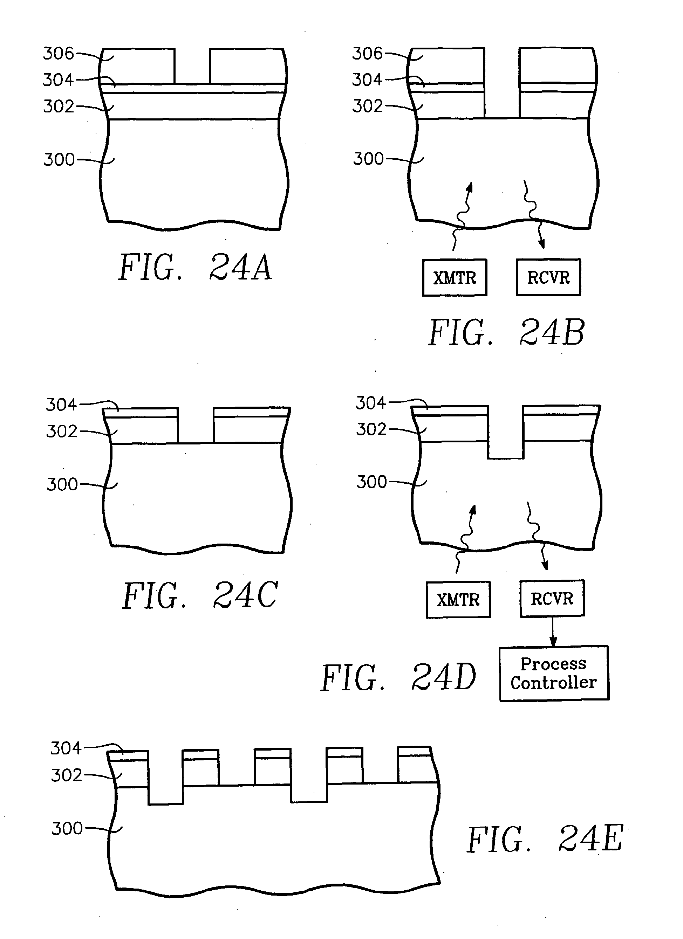

FIGS. 24A through 24E depict a process for fabricating a binary mask consisting of periodic chrome lines on a transparent quartz mask flanking periodic spaces of exposed quartz, alternate ones of the exposed quartz spaces being etched to a depth at which transmitted light is phase-shifted by a desired angle (e.g., 180 degrees). FIG. 24A depicts the initial structure consisting of a quartz mask substrate 300, a chrome layer 302, a chromium oxide anti-reflection coating 304 and a photoresist layer 306. In the step of FIG. 24B, the chrome and chromium oxide layers 302, 304 are etched in a process gas of C12+02+CF4 in a reactor chamber such as the chamber of FIGS. 14 or 17. In the step of FIG. 24C, the photoresist layer 306 is removed, after which the exposed portions of the quartz mask substrate 300 are etched as shown in FIG. 24D in a quartz-etching process gas of CHF3+CF4+Ar. The quartz etch step of FIG. 24D is carried out in a reactor chamber capable of sensing or monitoring the etch depth in the quartz mask substrate 300, such as the chamber of FIG. 15 or 16. During the etch process, the instantaneous etch depth is continually monitored, and the etch process is halted as soon as the target etch depth is reached on the mask 300. The final result is depicted in FIG. 24E.

### Continuous Monitoring of Etch Rate Distribution Across the Mask Surface:

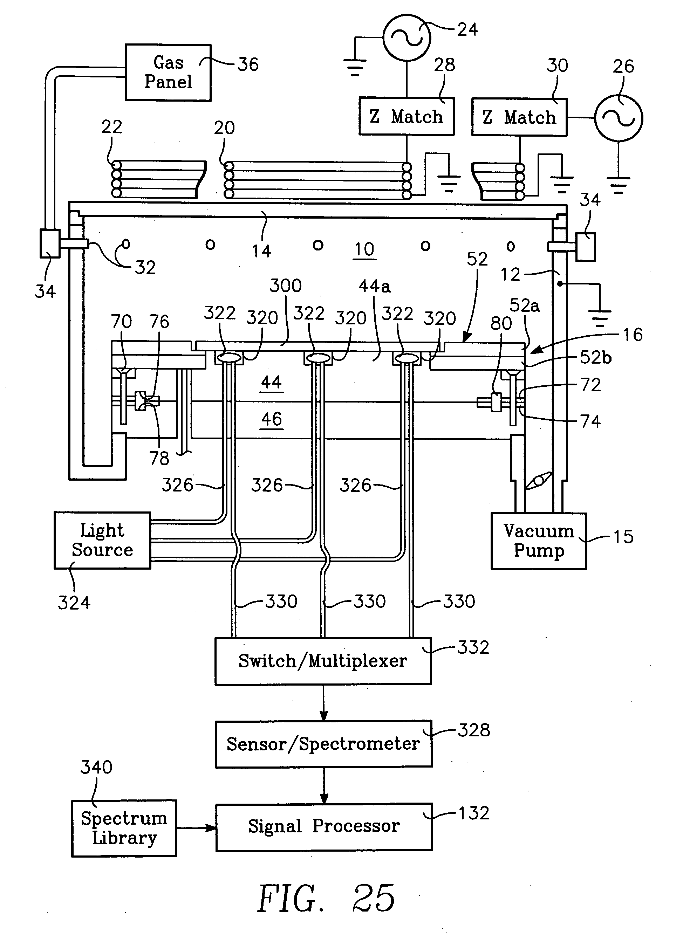

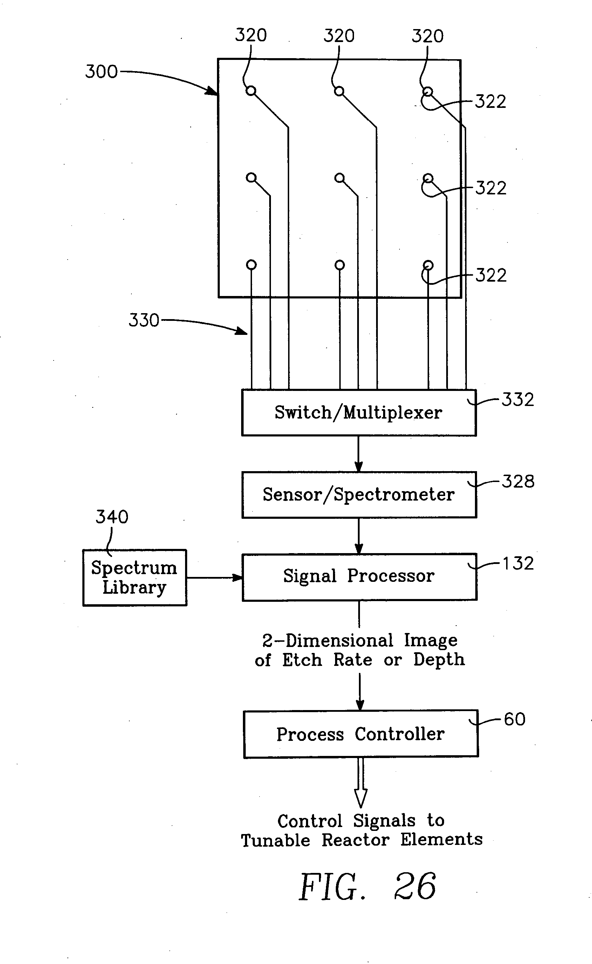

FIGS. 25 and 26 illustrate an embodiment of the wafer support pedestal 16 of FIG. 1 with a matrix of backside etch depth sensing elements (lenses and optical fibers) in the top surface of the cathode 44, continuously providing an instantaneous image or sample of the etch rate distribution or etch depth distribution across the entire surface of the mask or substrate during the etch process without interrupting the etch process or otherwise disturbing the mask substrate. The aluminum plateau 44a has a matrix of openings 320 in its top surface, each opening holding a lens 322 facing the backside of the mask substrate 300. A light source 324 provides light through output optical fibers 326 coupled to the respective lenses 322. The lenses 322 provide sufficient focusing to resolve interference fringes. An interference detector 328, which may be either a sensor that facilitates fringe counting or a spectrometer, is coupled to input optical fibers 330 coupled to the respective lenses 322. A switch or multiplexer 332 admits light to the detector 328 from each of the input optical fibers 330 sequentially. There are three modes in which the apparatus of FIG. 25 and 26 may operate. In a first mode, the etch depth in the field of view of a given one of the lenses 322 is computed from the interval between interference fringes. In a second mode, the detector 328 is a spectrometer and the etch depth in the field of view of a given one of the lenses 322 is computed from the lower wavelength peak interval of the multiple wavelength interference spectrum (corresponding to FIG. 13). In a third mode, the multiple wavelength interference spectrum is detected at a given instant of time and compared with a library 340 of spectra for which the corresponding etch depths are known. The etch rate distribution is computed from the etch depth and the elapsed time. This distribution records the etch nonuniformity of the process and is fed to the process controller 132/60. The controller 132/60 can respond by adjusting tunable features of the reactor to reduce non-uniformity in the etch rate distribution.

While the embodiment of FIGS. 25 and 26 is depicted as having a 3-by-3 matrix of etch depth sensors or lenses 322 in the top surface of the plateau 44a, any number of rows and columns in the matrix of such sensors may be employed so that the matrix is an n-by-m matrix, where m and n are suitable integers.

In one embodiment, the process controller may be programmed to deduce (from the etch rate distribution information supplied by the spectrometer or sensor 130) whether the etch rate distribution is center high or center low. The process controller 60 can respond to this information by adjusting certain tunable features of the reactor to decrease the non-uniformity. For example, the process controller 60 may change the RF power apportionment between the inner and outer coils 20, 22. Alternatively or in addition, the process controller 60 may change the height of the movable aluminum plate 112 in the reactor of FIGS. 6 and 7. Feedback from the array or matrix of etch depth sensing elements in the plateau 44a allows the process controller 60 to improve uniformity of etch rate distribution by continuous trial and error adjustments of the reactor tunable elements.

### Real-time Configurable Process Gas Distribution:

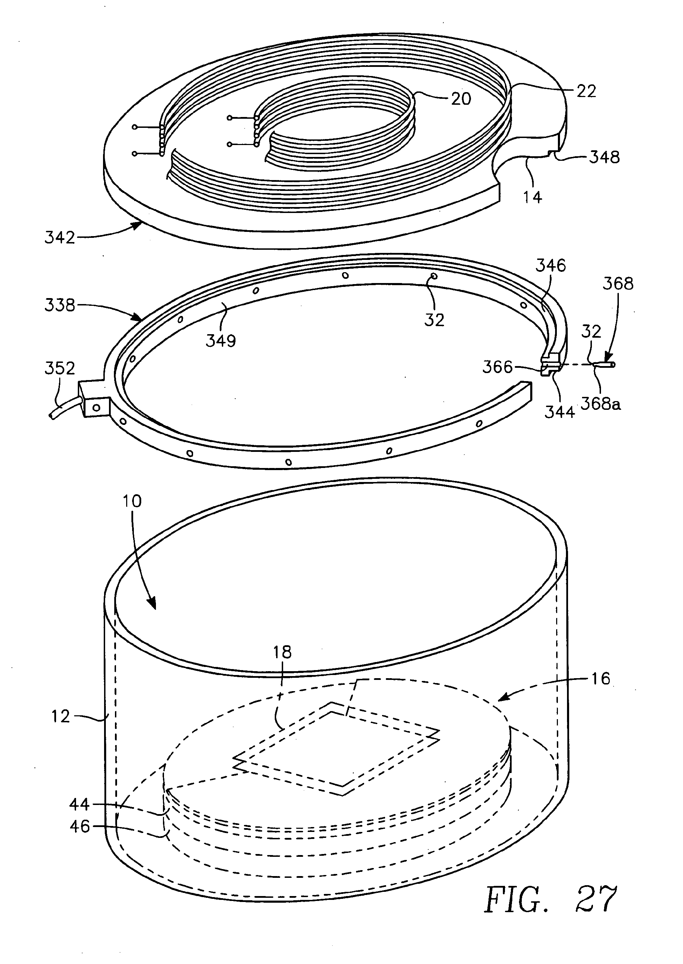

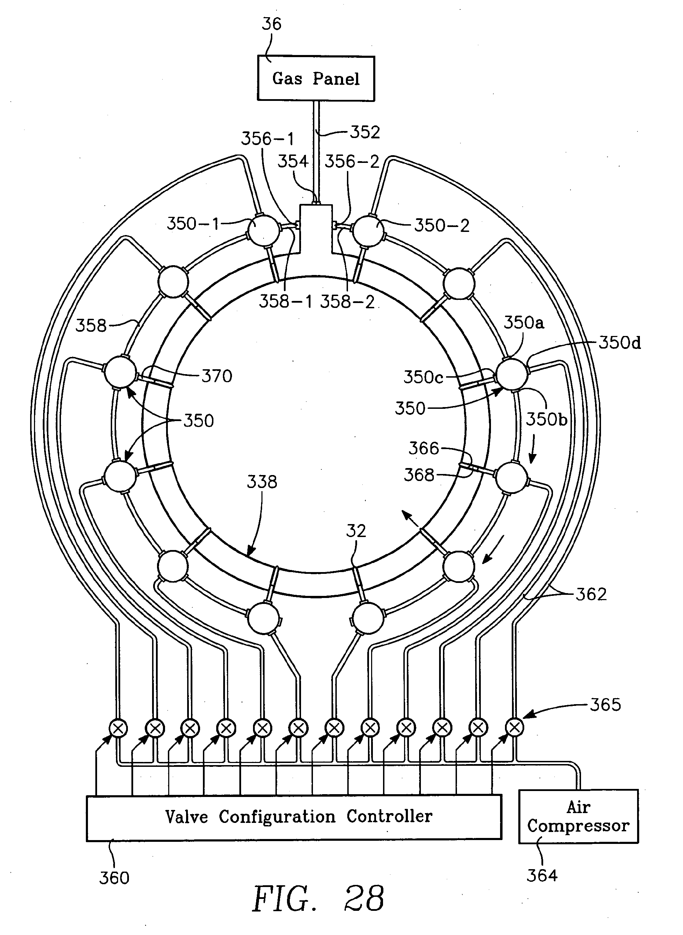

FIGS. 27 and 28 illustrate an embodiment of the plasma reactor of FIG. 1 having an array of individually controllable gas injection orifices or nozzles 32. By individually controlling the different nozzles 32, gas distribution within the chamber 10 can be changed to correct non-uniform distribution of etch rate across the workpiece or mask 18. In the illustrated embodiment, the array of gas injection nozzles 32 is located on the side wall 12 near the ceiling 14. For this purpose, the reactor includes a top ring 338 that is held between the top of the side wall 12 and a removable lid 342 having a bottom surface that constitutes the ceiling 14. An exterior shoulder 344 in the bottom surface of the top ring 338 rests on the top surface of the sidewall 12. An interior shoulder 346 on the top surface of the ring receives the edge of the lid 342. An external shoulder 348 is provided in the bottom surface of the lid 342 that rests in the internal shoulder 346 of the ring 338. The gas injection orifices or nozzles 32 are formed in the vertical interior surface 349 of the ring 338. Gas flow to each of the injection nozzles 32 is individually controlled by a separate valve 350, there being one valve 350 for each of the nozzles 32. Process gas supplied from the gas panel 36 flows through a gas supply line 352 that is coupled to an input port 354 formed on the ring 338. Gas supply outlets 356-1, 356-2 formed on the ring 338 output the process gas received at the input port 354. A series of disconnectable gas flow lines 358 form series connections outside the periphery of the ring 338 that communicate process gas from each of the gas supply outlets or ports 356 to a corresponding set of the valves 350.

In a preferred embodiment, each valve 350 is pneumatically controlled, and has an input flow-through port 350a and an output flow-through port 350b, a controlled gas outlet port 350c and a pneumatic pressure control input port 350d. The outlet port 350c provides a controlled process gas flow to a corresponding one of the nozzles 32. Process gas flows freely from the input flow-through port 350a to the output flow-through port 350b. Compressed air pressure at the control input port 350d determines whether any of the process gas passing through the flow-through ports 350a, 350b is diverted to the gas outlet port 350c. Such pneumatically controlled valves are well-known, and therefore their internal structure need not be disclosed here. The gas flow lines 358-1 and 358-2 are connected from the gas supply outlets 356-1, 356-2 to the input flow-through ports 350a of the valves 350-1, 350-2. Each of the remaining gas flow lines 358 are connected from the output flow-through port 350a of one valve 350 to the input flow-through port 350b of a successive valve 350. Thus, gas flow through the series of valves 350 in the left side of the drawing of FIG. 28 is counter-clockwise, while gas flow through the series of valves 350 in the right side of the drawing of FIG. 28 is clockwise.

Gas flow from each output port 356 to the series of valves 350 connected to it is not blocked by any intervening valve 350 in the series. Each valve 350 can be turned "on" without turning on or off any of the other valves 350 to provide gas flow to a corresponding gas injection orifice 32, and can be turned "off" to terminate gas flow to that injection orifice. A valve configuration processor 360 controls all of the valves 350 and can turn on or off any combination of the valves 350 via valve control links 362. As stated above, in a preferred embodiment the valves 350 are pneumatic valves and the control links 362 are pneumatic (air) tubes in order to avoid the presence of electrical conductors near the coil antennas 20, 22. In the embodiment of FIG. 28, a compressor 364 furnishes air under pressure to an array of solenoid (i.e., electrically controlled) valves 365 that control application of the pressurized air to pneumatic control inputs 350a of the respective pneumatic valves 350. The valve configuration processor 360 controls the solenoid valves 365 through electrical links that are remote from the coil antennas 20, 22.

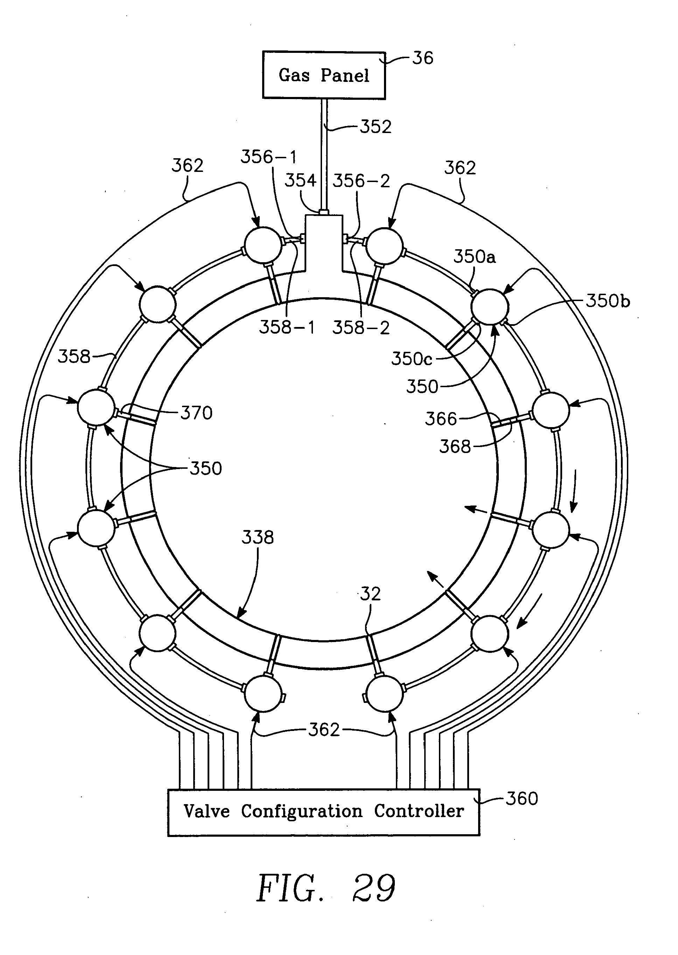

FIG. 29 depicts a modification of the embodiment of FIG. 28 in which the valves 350 are each electrically controlled rather than pneumatically controlled. In FIG. 29, each of the control links 362 is an electrical line extending directly from the controller 360 to a corresponding one of the valves 350, and the air compressor 364 and array of compressed air solenoid valves 365 are eliminated.

Referring again to FIGS. 27 and 28, each orifice 32 is formed from a radial cylindrical passage 366 through the ring 338. A hollow cylindrical sleeve 368 is received within the passage 366, the tip 368a of the sleeve 368 forming the gas injection orifice. The injection orifice diameter at the tip 368a having a diameter on the order of .030 inch, for example. Each sleeve 368 may be formed of a ceramic material and may be removable. The controlled gas outlet port 350c of each valve 350 is connected through a short gas supply line 370 to the outer end of the corresponding radial passage 366. The entire gas distribution assembly is modular and quickly disassembled by the connection (or disconnection) of each of the outer gas supply lines 358 and the short gas supply lines 370, the sleeves 368 being separately removable from the holes 366. In this way, the gas distribution components and assembly support on the ring 338 are readily replaced on an individual basis, without requiring removal or replacement of more expensive components of the reactor, such as the ring 338 for example.

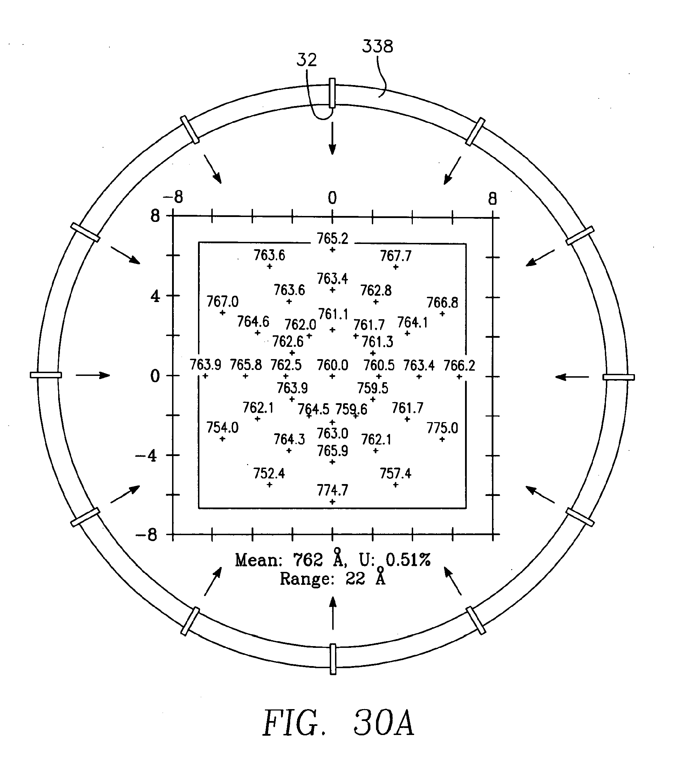

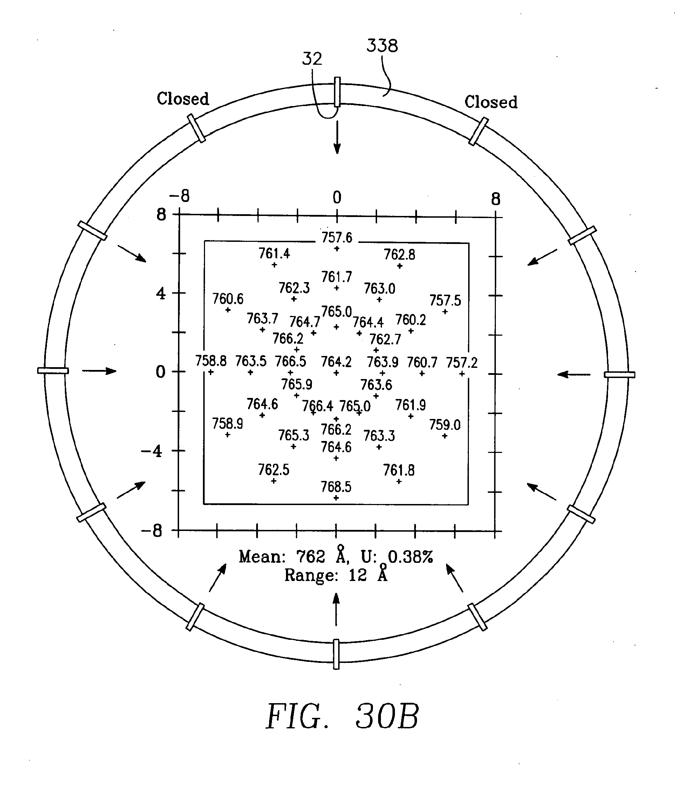

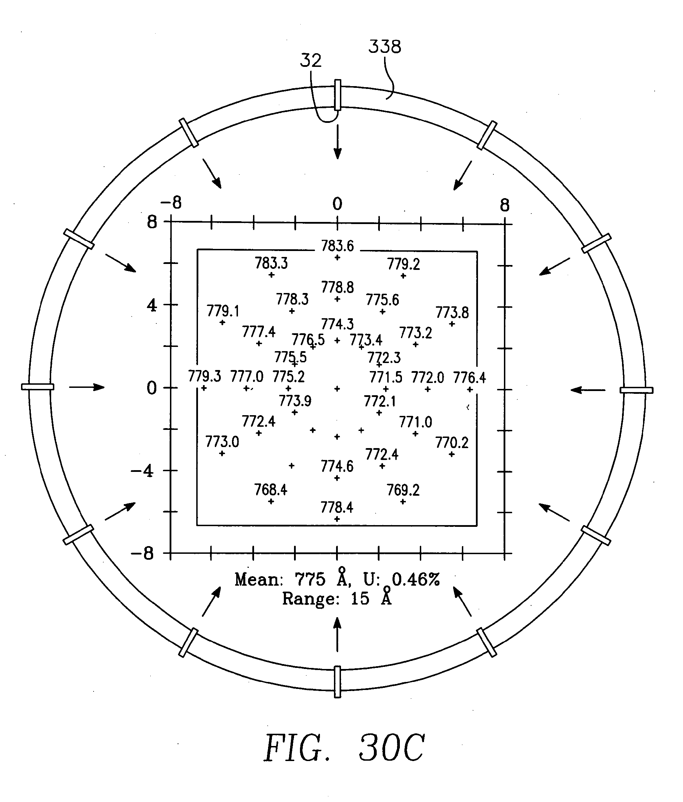

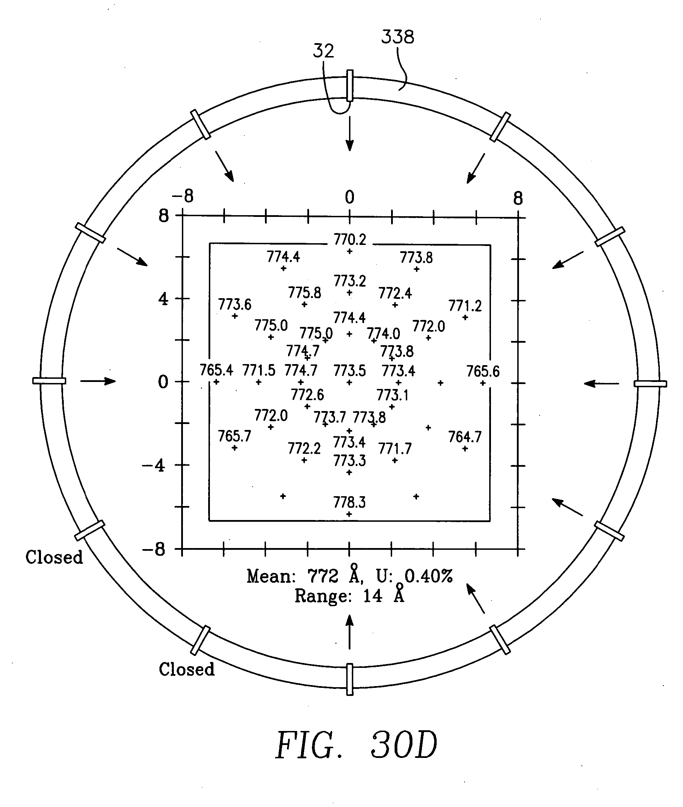

FIGS. 30A through 30D are graphs of the etch depth distribution over the mask 18 obtained in a fixed time period of an etch process carried out in the reactor of FIGS. 27 and 28 for different valve configurations. The etch distribution of FIG. 30A was obtained when all valves 350 were open, and is generally a center low etch distribution, with a high non-uniformity or variation of 0.51% across the mask surface. The distribution of FIG. 30B was obtained with a pair of adjacent valves 350a, 350b closed, and the remaining valves 350 being open, and a more nearly uniform distribution, with a non-uniformity or variation of only 0.38%. FIG. 30C was obtained by returning the valve configuration back to the state in which all valves 350 were open. The distribution of FIG. 30C is more center low. The distribution of FIG. 30D was obtained by closing a different pair of adjacent valves 350c, 350d. The resulting distribution was more uniform and less center-low, with a variation of only 0.40%.

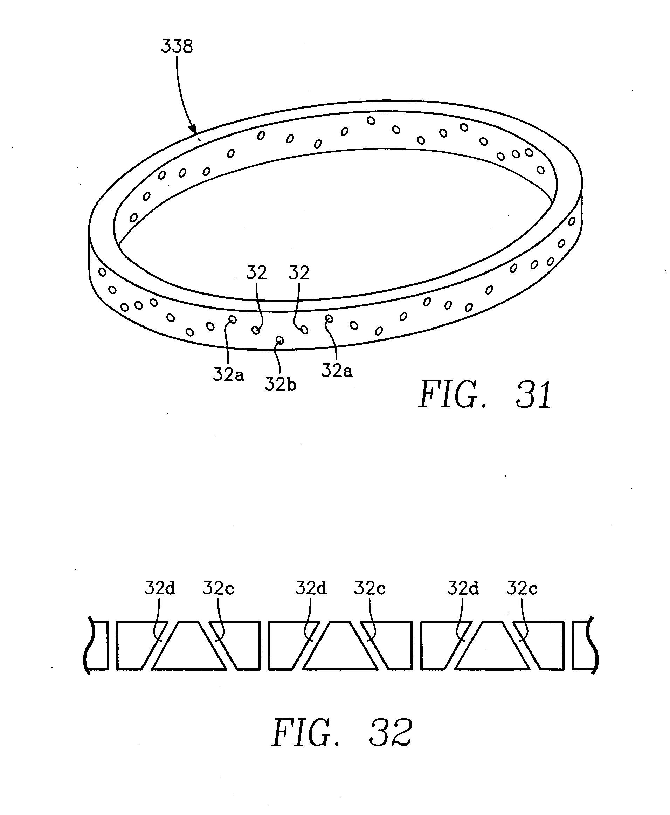

FIG. 31 illustrates an alternative embodiment in which the gas injection nozzles 32 are placed in a zig-zag or "W" pattern in the ring 338. Each nozzle is independently controlled as in the foregoing embodiments. The injection pattern may be moved relative to the ceiling by activating only the top row 32a or only the bottom row 32b of nozzles. The distance between nozzles may be changed by activating only selected nozzles 32 (e.g., every third nozzle or every fourth nozzle). FIG. 32 is a cross-sectional view of a portion of the ring 338 depicting how the nozzles 32 may be arranged to spray in different directions. Large changes in gas distribution may be obtained by the valve configuration controller 360 turning on only those nozzles 32 oriented in a particular direction, for example. For example, all the nozzles 32c angled toward the right in the view of FIG. 32 may be simultaneously turned on to the exclusion of all others. A large change or correction may be obtained by turning on all nozzles 32d angled toward the left while turning off all others including all the right-angled nozzles 32c, for example.

### Controlling Tunable Reactor Elements with Feedback from an Array of Backside Etch Depth Measurement Sensors:

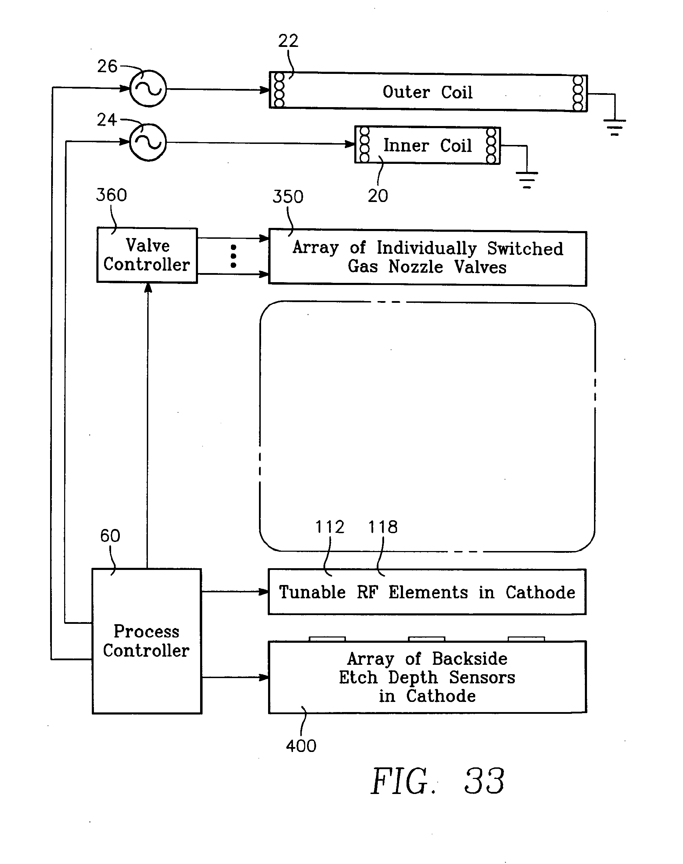

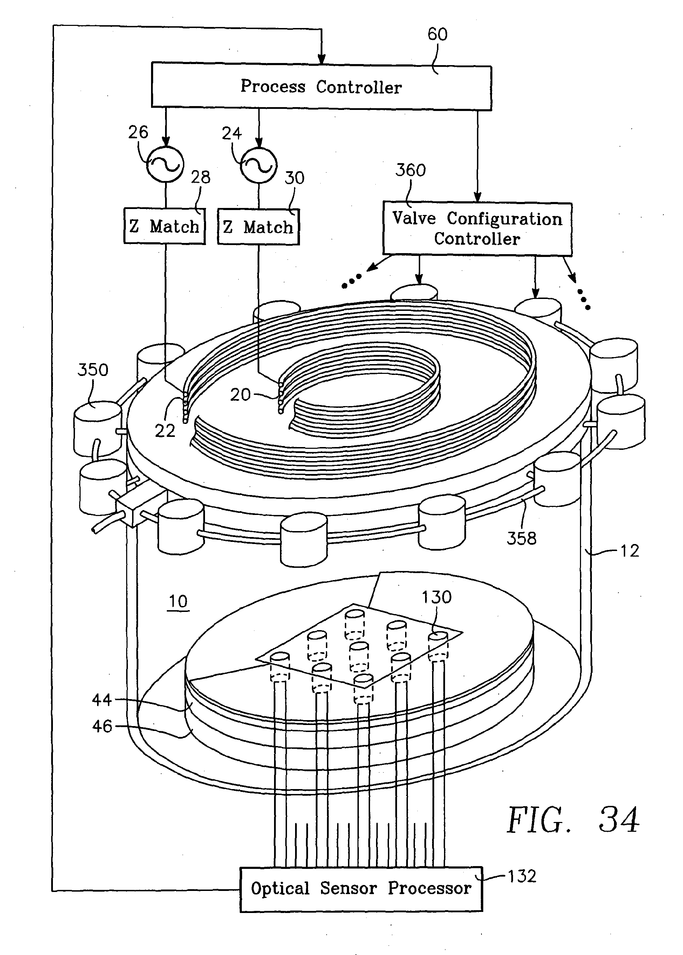

Referring now to FIGS. 33 and 34, feedback control of a tunable elements of the mask etch plasma reactor is provided using the output of the two-dimensional array of backside etch depth sensors of FIGS. 25 and 26. The tunable element or elements may include the array of individually controlled gas injection nozzles 32 of FIGS. 27 and 28. Alternatively, or in addition, the tunable element controlled in such a feedback loop may include the RF power apportionment between the inner and outer coils 20, 22 or the height of the movable aluminum plate 112 in the reactor of FIGS. 6 and 7.

Feedback from the array or matrix of etch depth sensing elements 130 of FIGS. 25 and 26 allows the process controller 60 to improve uniformity of etch rate distribution by continuous trial and error adjustments of the reactor tunable elements. In FIG. 33, a feedback loop begins with the array 400 of the backside etch depth sensors 130 of FIGS. 25 and 26. The process controller 60 is programmed to use the image of instantaneous etch depth measurements across the mask 18 to infer the locations and magnitudes of non-uniformities in the etch rate on the mask 18 and to deduce the likeliest changes in a particular tunable element of the reactor that would reduce or eliminate such non-uniformities. This information is converted by the processor 60 into a command (or commands) to be sent to any one or some or all of the tunable elements of the reactor. Thus, FIG. 33 shows output signal paths from the process controller 60 to the following tunable elements, any one or all of which may be present in the reactor: the inner and outer antenna RF power generators 24, 26 (for inner and outer RF power apportionment); the actuator 118 for the movable aluminum plate 112; the nozzle array controller 360 of the array of controllable nozzles 32.

The feedback loop may be operated continuously during the entire mask etch process to improve etch rate distribution uniformity across the mask 18 by reducing non-uniformities perceived by the processor 60 from the "image" of etch rate distribution across the mask 18. The feedback can be governed by software in the processor 60 for performing trial and error corrections. Alternatively, the software in the processor 60 can incorporate commercially available neural training and feedback learning techniques that enable the processor 60 to respond more intelligently to perceived non-uniformities in the etch rate distribution. Such software techniques form no part of the present invention.

In one embodiment, the feedback commands to the tunable element (or elements) may be generated to reduce the variation among the array of etch depth sensors. In another embodiment, the feedback may be selected to address a particular non-uniformity. For example, the etch rate distribution sensed by the array of sensors 130 may be very high in one quadrant or corner of the mask 18, in which case the valve configuration processor is commanded to reduce gas flow in that one quadrant by a limited (trial) amount. If this expedient meets with limited success according to subsequent images of the etch rate distribution obtained from the array of backside sensors 130, then this adjustment in the gas flow distribution may be increased. This cycle of adjustments and corrections may be continued until there is no further improvement in etch rate distribution uniformity.

Other non-uniformities may be handled on a similar basis after the first one has been corrected. For example, the etch rate in a different location may be extremely high, in which case the gas flow to that location is reduced as long as this results in some reduction in this non-uniformity over a number of samples of the etch rate distribution "image" from the array of backside sensors 130.

In the case of etch rate distribution non-uniformities that are symmetrical (e.g., a center-high or a center-low distribution) symmetrical tunable elements such as the height of the aluminum plate 112 or the RF power apportionment between the inner and outer coils 20, 22 may be employed by the processor 60 to reduce the non-uniformity using the feedback control loop. For example, a center-low etch rate distribution may be rendered less non-uniform by the processor 60 increasing the etch rate in the center of the mask 18 by either (or both) raising the aluminum plate 112 or increasing the apportionment of RF power to the inner coil 20 (relative to the outer coil 22). In the feedback loop, this change may be small initially, and as the etch distribution image from the array of backside sensors 130 improves in uniformity, the position of the aluminum plate and/or the apportionment of power to the inner coil 20 may be further increased. This cycle may continue until no further improvement is observed. All of the foregoing techniques may be embedded in the software executed by the process controller 60.

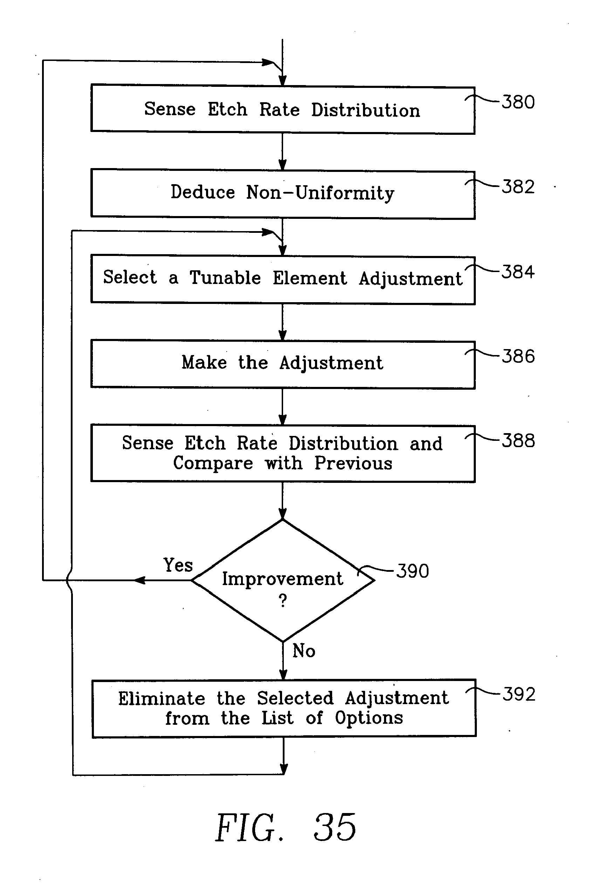

FIG. 35 depicts one possible example of a feedback cycle performed by the process controller 60 in the embodiment of FIGS. 33 and 34. First, the processor 60 obtains the latest two-dimensional image of etch rate across the mask surface from the array of backside sensors 130 (block 380 of FIG 35). From this image, the processor 60 deduces the pattern of non-uniformity in etch rate distribution (block 382) and selects an adjustment to one of the tunable elements of the reactor from a list of options that may reduce the non-uniformity (block 384). After making this adjustment (block 386), the processor 60 obtains the latest etch rate distribution image (block 388) and compares it with the previous image taken prior to the adjustment. If there is an improvement (a lessening in the non-uniformity), the processor 60 repeats the same cycle, probably resulting in further increases in the same successful adjustment. If there is no improvement (NO branch of block 390), then the selected adjustment is removed from the list of options (block 392), and a different adjustment is selected by returning to the step of block 384.

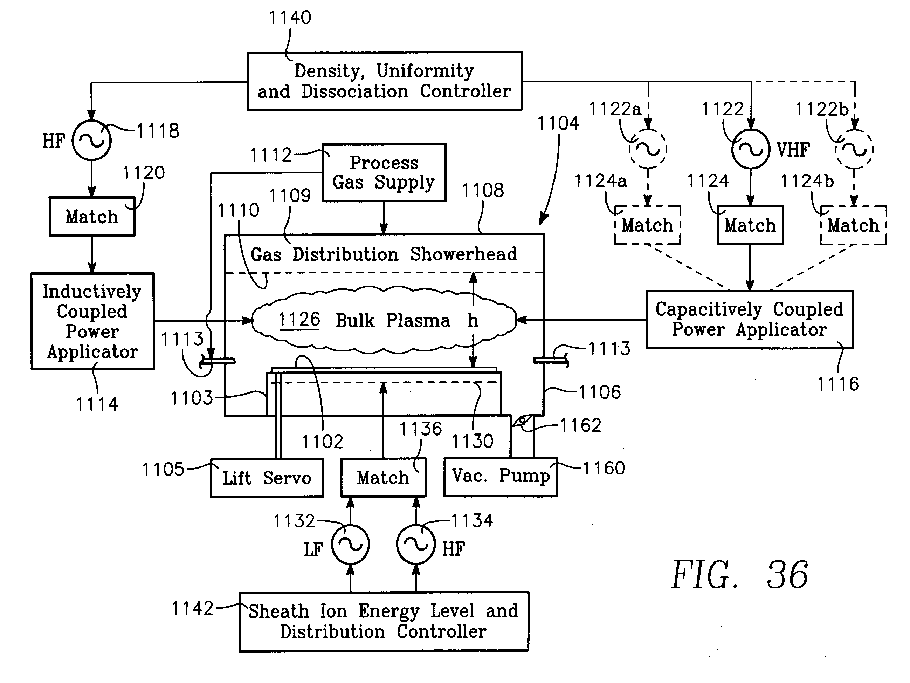

FIG. 36 depicts a plasma reactor for processing a workpiece 1102, which may be a semiconductor wafer, held on a workpiece support 1103, which may (optionally) be raised and lowered by a lift servo 1105. The reactor consists of a chamber 1104 bounded by a chamber sidewall 1106 and a ceiling 1108. The ceiling 1108 may comprise a gas distribution showerhead 1109 having small gas injection orifices 1110 in its interior surface, the showerhead 1109 receiving process gas from a process gas supply 1112. In addition, process gas may be introduced through gas injection nozzles 1113. The reactor includes both an inductively coupled RF plasma source power applicator 1114 and a capacitively coupled RF plasma source power applicator 1116. The inductively coupled RF plasma source power applicator 1114 may be an inductive antenna or coil overlying the ceiling 1108. In order to permit inductive coupling into the chamber 1104, the gas distribution showerhead 1109 may be formed of a dielectric material such as a ceramic. The VHF capacitively coupled source power applicator 1116 is an electrode which may be located within the ceiling 1108 or within the workpiece support 1103. In an alternative embodiment, the capacitively coupled source power applicator 1116 may consist of an electrode within the ceiling 1108 and an electrode within the workpiece support 1103, so that RF source power may be capacitively coupled from both the ceiling 1108 and the workpiece support 1103. (If the electrode is within the ceiling 1108, then it may have multiple slots to permit inductive coupling into the chamber 1104 from an overhead coil antenna.) An RF power generator 1118 provides high frequency (HF) power (e.g., within a range of about 10 MHz through 27 MHz) through an optional impedance match element 1120 to the inductively coupled source power applicator 1114. Another RF power generator 1122 provides very high frequency (VHF) power (e.g., within a range of about 27 MHz through 200 MHz) through an optional impedance match element 1124 to the capacitively coupled power applicator 1116. The efficiency of the capacitively coupled power source applicator 1116 in generating plasma ions increases as the VHF frequency increases, and the frequency range preferably lies in the VHF region for appreciable capacitive coupling to occur. As indicated symbolically in FIG. 36, power from both RF power applicators 1114, 1116 is coupled to a bulk plasma 1126 within the chamber 1104 formed over the workpiece support 1103. RF plasma bias power is capacitively coupled to the workpiece 1102 from an RF bias power supply coupled to (for example) an electrode 1130 inside the workpiece support and underlying the wafer 1102. The RF bias power supply may include a low frequency (LF) RF power generator 1132 and another RF power generator 1134 that may be either a medium frequency (MF) or a high frequency (HF) RF power generator. An impedance match element 1136 is coupled between the bias power generators 1132, 1134 and the workpiece support electrode 1130. A vacuum pump 1160 evacuates process gas from the chamber 1104 through a valve 1162 which can be used to regulate the evacuation rate. The evacuation rate through the valve 1162 and the incoming gas flow rate through the gas distribution showerhead 1109 determine the chamber pressure and the process gas residency time in the chamber.

The plasma ion density increases as the power applied by either the inductively coupled power applicator 1114 or VHF capacitively coupled power applicator 1116 is increased. However, they behave differently in that the inductively coupled power promotes more dissociation of ions and radicals in the bulk plasma and a center-low radial ion density distribution. In contrast, the VHF capacitively coupled power promotes less dissociation and a center high radial ion distribution, and furthermore provides greater ion density as its VHF frequency is increased.

The inductively and capacitively coupled power applicators may be used in combination or separately, depending upon process requirements. Generally, when used in combination, the inductively coupled RF power applicator 1114 and the capacitively coupled VHF power applicator 1116 couple power to the plasma simultaneously, while the LF and HF bias power generators simultaneously provide bias power to the wafer support electrode 1130. As will be discussed below, the simultaneous operation of these sources enables independent adjustment of the most important plasma processing parameters, such as plasma ion density, plasma ion radial distribution (uniformity), dissociation or chemical species content of the plasma, sheath ion energy and ion energy distribution (width). For this purpose, a source power controller 1140 regulates the source power generators 1118, 1122 independently of one another (e.g., to control their ratio of powers) in order to control bulk plasma ion density, radial distribution of plasma ion density and dissociation of radicals and ions in the plasma, as will be described in a later portion of this specification. The controller 1140 is capable of independently controlling the output power level of each RF generator 1118, 1122. In addition, or alternatively, the controller 1140 is capable of pulsing the RF output of either one or both of the RF generators 1118, 1122 and of independently controlling the duty cycle of each, or of controlling the frequency of the VHF generator 1122 and, optionally, of the HF generator 1118. In addition, a bias power controller 1142 controls the output power level of each of the bias power generators 1132, 1134 independently in order to control both the ion energy level and the width of the ion energy distribution, as will be described below. The controllers 1140, 1142 are operated to carry out various methods of the invention.

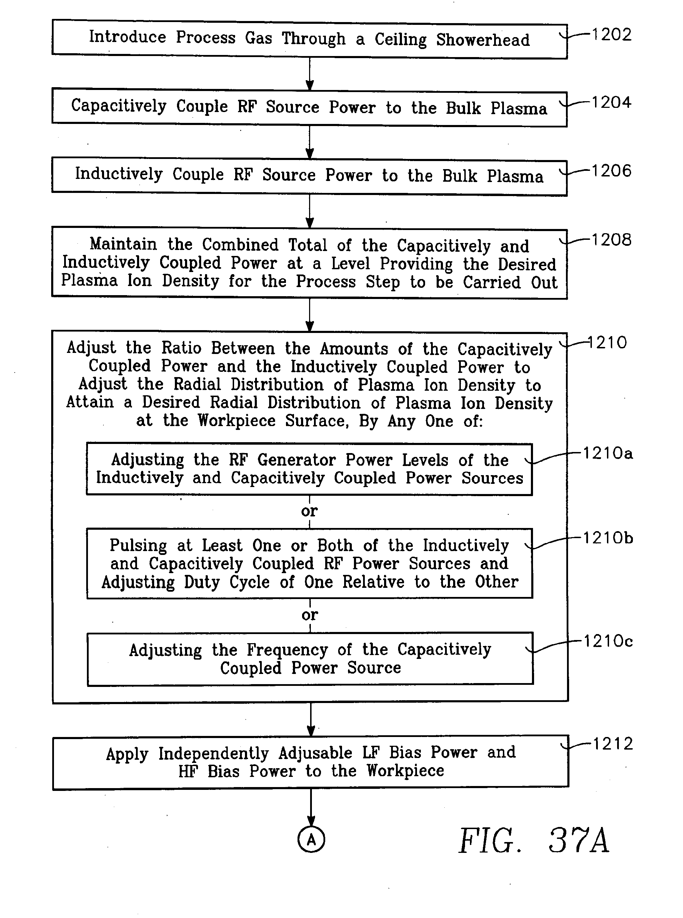

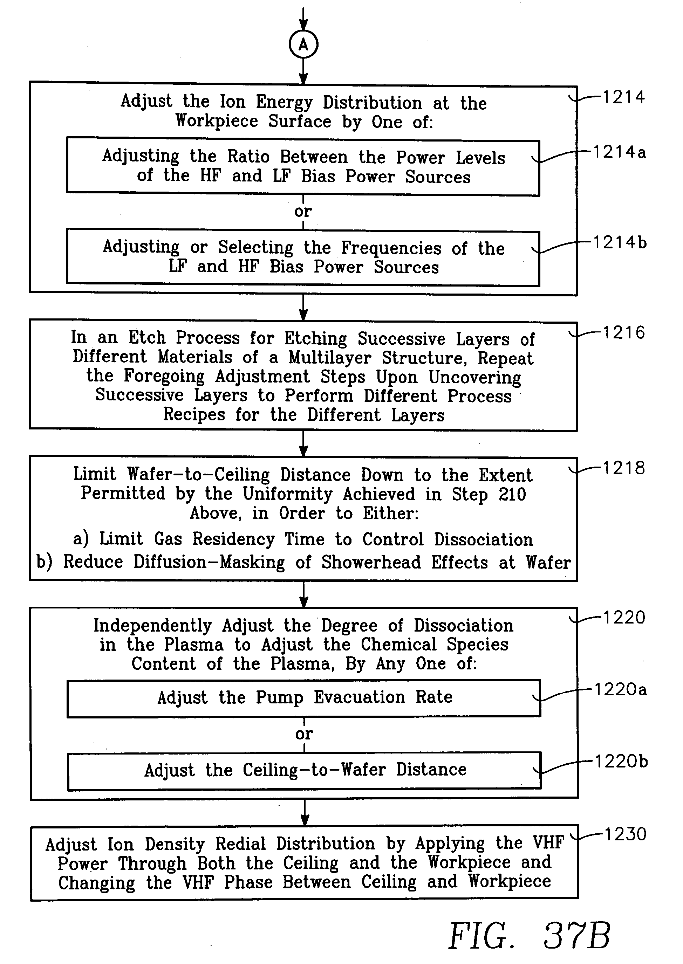

In accordance with a first method of the invention depicted in FIG. 37, plasma ion density, plasma ion density uniformity, sheath ion energy and ion energy distribution (width) are controlled independently of one another. The method of FIG. 37 includes introducing process gas, preferably through the ceiling gas distribution showerhead 1109 (block 1202 of FIG. 37). The method continues by capacitively coupling VHF source power to the bulk plasma (block 1204) while inductively coupling RF source power to the bulk plasma (block 1206). The user establishes a certain plasma ion density in accordance with a particular process step. This is accomplished by maintaining the combined total of the VHF capacitively coupled source power and the inductively coupled source power at a level providing the desired plasma ion density for the process step to be carried out (block 1208). At the same time, the radial distribution of plasma ion density at the wafer surface is customized (e.g., to make as uniform as possible) while maintaining the desired plasma ion density. This is accomplished by adjusting the ratio between the amounts of the VHF capacitively coupled power and the inductively coupled power (block 1210). This apportions the radial ion distribution between the center-low distribution promoted by the inductively coupled power and the center-high distribution promoted by the VHF capacitively coupled power. As will be described below in this specification, this can be accomplished without perturbing the ion density by maintaining the total RF power nearly constant while changing only the ratio between the power delivered by the HF and VHF generators 1118, 1122.

The adjustment of step 1210 can be carried out by any one (or a combination) of the following steps: A first type of adjustment consists of adjusting the RF generator power levels of the inductively and capacitively coupled power sources 1118, 1122 (block 1210a of FIG. 37). Another type consists of pulsing at least one or both of the inductively and capacitively coupled RF power generators 1118, 1122 and adjusting the duty cycle of one relative to the other (block 1210b of FIG. 37). A third type consists of adjusting the effective frequency of the capacitively coupled power VHF generator 1122 (block 1210c of FIG. 37), in which plasma ion density increases as the VHF frequency is increased. Adjusting the effective VHF frequency of the capacitively coupled plasma source power may be accomplished in a preferred embodiment by providing two VHF generators 1122a, 1122b of fixed but different VHF frequencies (i.e., an upper VHF frequency f₁ output by the generator 1122a and a lower VHF frequency f₂ output by the generator 1122b) whose combined outputs are applied (through impedance matches 1124a, 1124b) to the capacitive power applicator. Changing the effective VHF frequency f_{eff} within a range bounded by the upper and lower frequencies f₁, f₂, is performed by varying the ratio between the output power levels a₁, a₂, of the two generators 1122a, 1122b. The effective frequency f_{eff} may be approximated to first order as a function of the frequencies f₁ and f₂ of the two VHF generators 1122a, 1122b, respectively, and their respective adjustable output power levels, a₁ and a₂, as follows: f_{eff} = (a₁f₁ + f₂a₂)/(a₁ + a₂). While the foregoing example involves two VHF generators, a larger number may be employed if desired.

The VHF capacitive source can efficiently create plasma density without creating high RF voltages in the plasma, which is similar to an inductively coupled plasma (ICP) source. In contrast, the LF and HF bias sources efficiently create high RF voltages in the plasma but contribute little to plasma density. Therefore, the combination of the VHF source (or VHF sources) and the ICP source allows the plasma to be produced without the side effect of creating large RF voltages within the plasma. As a result, the RF voltage produced by the LF of HF source applied to wafer pedestal can operate independently from the plasma density creating source. The VHF source can be operated independently from the ICP source, with an ability to create plasma density in combination with the ICP (whereas the traditional ICP source employs an HF or LF capacitively coupled power source connected to the wafer pedestal to create RF voltage on the wafer only).

The method further includes coupling independently adjustable LF bias power and HF bias power supplies to the workpiece (block 1212). The controller 1142 adjusts the ion energy level and ion energy distribution (width or spectrum) at the workpiece surface by simultaneous adjustments of the two RF bias power generators 1132, 1134 (block 1214). This step is carried out by any one of the following: One way is to adjust the ratio between the power levels of the HF and LF bias power sources 1132, 1134 (block 1214a of FIG. 37). Another (less practical) way is adjusting or selecting the frequencies of the LF and HF bias power sources (block 1214b of FIG. 37). In a first embodiment, the LF and HF frequencies are applied to the ESC electrode 1130 while the VHF source power is applied to the gas distribution showerhead 1110 (in which case the showerhead 1110 is the CCP applicator 1116) while the ICP applicator 1114 overlies the showerhead 1110. In a second embodiment, the VHF source power is applied to the ESC electrode 1130 along with the HF and LF bias frequencies, while the ICP power applicator 1114 overlies the showerhead 1110.

If the method is used in an etch process for etching successive layers of different materials of a multilayer structure, the plasma processes for etching each of the layers may be customized to be completely different processes. One layer may be etched using highly dissociated ion and radical species while another layer may be etched in a higher density plasma than other layers, for example. Furthermore, if chamber pressure is changed between steps, the effects of such a change upon radial ion density distribution may be compensated in order to maintain a uniform distribution. All this is accomplished by repeating the foregoing adjustment steps upon uncovering successive layers of the multilayer structure (block 1216).

The superior uniformity of plasma ion radial distribution achieved in the step of block 1210 makes it unnecessary to provide a large chamber volume above the wafer. Therefore, the distance between the wafer and the plasma source may be reduced without compromising uniformity. This may be done when the reactor is constructed, or (preferably) the wafer support 1103 may be capable of being lifted or lowered relative to the ceiling 1108 to change the ceiling-to-wafer distance. By thus decreasing the chamber volume, the process gas residency time is decreased, providing independent control over dissociation and plasma species content. Also, reducing the ceiling-to-wafer distance permits the gas distribution effects of the gas distribution showerhead 1109 to reach the wafer surface before being masked by diffusion, a significant advantage. Thus, another step of the method consists of limiting the ceiling-to-wafer distance to either (a) limit residency time or (b) prevent the showerhead gas distribution pattern from being masked at the wafer surface by diffusion effects (block 1218 of FIG. 37). One advantage is that inductive coupling can now be employed without requiring a large ceiling-to-wafer distance to compensate for the center-low ion distribution characteristic of an inductively coupled source. In fact, the ceiling-to-wafer distance can be sufficiently small to enable an overhead gas distribution showerhead to affect or improve process uniformity at the wafer surface.

The chemical species content of the plasma may be adjusted or regulated independently of the foregoing adjustments (e.g., independently of the adjustment of the radial ion density distribution of the step of block 1210) by adjusting the degree of dissociation in the plasma, in the step of block 1220 of FIG. 37. This step may be carried out by adjusting the rate at which the chamber 1104 is evacuated by the vacuum pump 1160 (block 1220a of FIG. 37), for example by controlling the valve 1162, in order to change the process gas residency time in the chamber. (Dissociation increases with increasing residency time and increasing chamber volume.) Alternatively (or additionally), the adjustment of dissociation may be carried out by adjusting the ceiling-to-wafer distance so as to alter the process gas residency time in the chamber (block 1220b of FIG. 37). This may be accomplished by raising or lowering the workpiece support 1103 of FIG. 36. The foregoing measures for adjusting dissociation in the plasma do not significantly affect the ratio of inductive and capacitive coupling that was established in the step of block 1210 for adjusting ion distribution or uniformity. Thus, the adjustment of the dissociation or chemical species content of step 1220 is made substantially independently of the adjustment of plasma ion density distribution of step 1210.

In an alternative embodiment, the capacitively coupled source power applicator 1116 consists of electrodes in both the ceiling 1108 and the workpiece support 1103, and VHF power is applied simultaneously through the electrodes in both the ceiling 1108 and the workpiece support 1103. The advantage of this feature is that the phase of the VHF voltage (or current) at the ceiling may be different from the phase at the workpiece support, and changing this phase difference changes the radial distribution of plasma ion density in the chamber 1104. Therefore, an additional step for adjusting the radial distribution of plasma ion density is to adjust the phase difference between the VHF voltage (or current) at the workpiece support 1103 and the VHF voltage (or current) at the ceiling 1108. This is indicated in block 1230 of FIG. 37. This adjustment may or may not require changing the ratio between capacitive and inductive coupling selected in the step of block 1210.

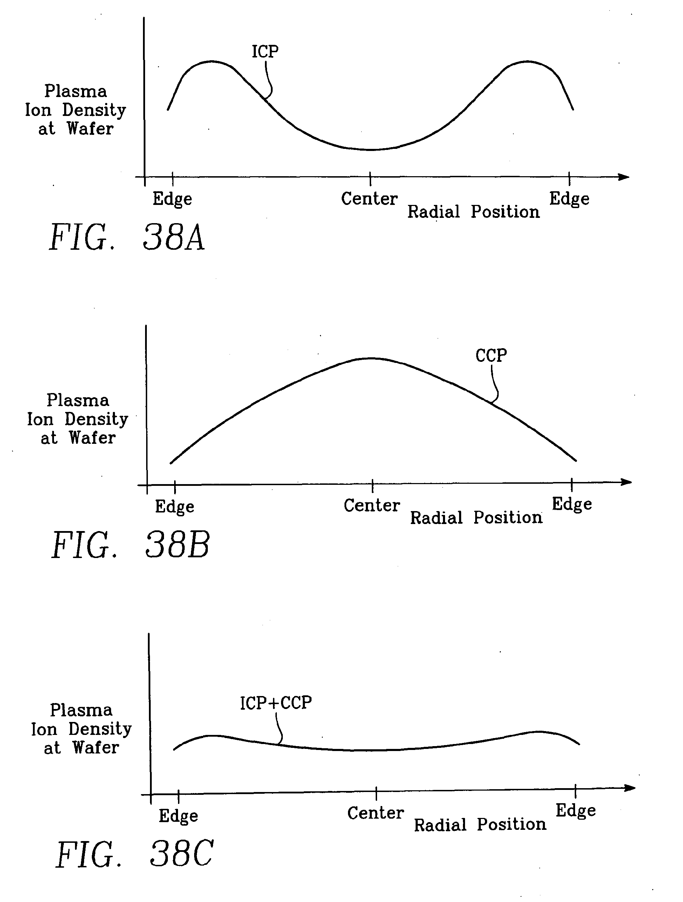

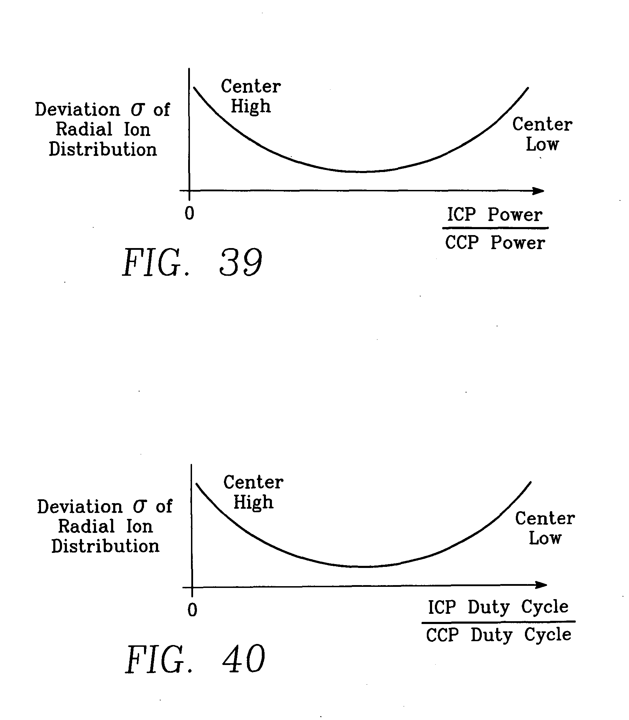

FIGS. 38A, 38B and 38C show how the combination of a center-low or "M"-shaped inductively coupled plasma ion density distribution (FIG. 38A) with a center-high capacitively coupled plasma ion density distribution (FIG. 38B) results in a more ideal or more nearly uniform plasma ion density distribution (FIG. 38C) that corresponds to the superposition of the distributions of FIGS. 38A and 38B. The ideal distribution of FIG. 38C is achieved by a careful adjustment of the amount of inductive and capacitive coupling of the two sources 1118, 1122 of FIG. 36. A high ratio of capacitively coupled power leads to a more center-high distribution, while a high ratio of inductively coupled power leads to a more center-low distribution. Different ratios will result in the ideal distribution at different chamber pressures. One way of apportioning inductive and capacitive coupling is to apportion the amount of RF power of the two generators 1118, 1122. FIG. 39 depicts how the ratio between the output power levels of the generators 1118, 1122 affects the radial ion distribution. The minimum or dip in the curve of FIG. 39 corresponds to an ideal power ratio at which the non-uniformity or deviation in ion distribution is the least. Another way of apportioning between inductively and capacitively coupled power is to pulse at least one (or both) of the two generators 1118, 1122, and control the pulse duty cycle. For example, one of them (the inductive source 1118) may be pulsed and the other (the capacitive source 1122) may be continuous, and the two are balanced by adjusting the duty cycle of the capacitively coupled source 1122. Alternatively, both may be pulsed, and apportioning is done by controlling the ratio of the duty cycles of the two sources. The results are depicted in FIG. 40, in which a high ratio of inductively coupled-to-capacitively coupled duty cycles results in more inductively coupled power reaching the plasma and a more center-low distribution, A high ratio of capacitively coupled power-to-inductively coupled power results in more capacitively coupled power in the plasma, providing a center-high distribution.

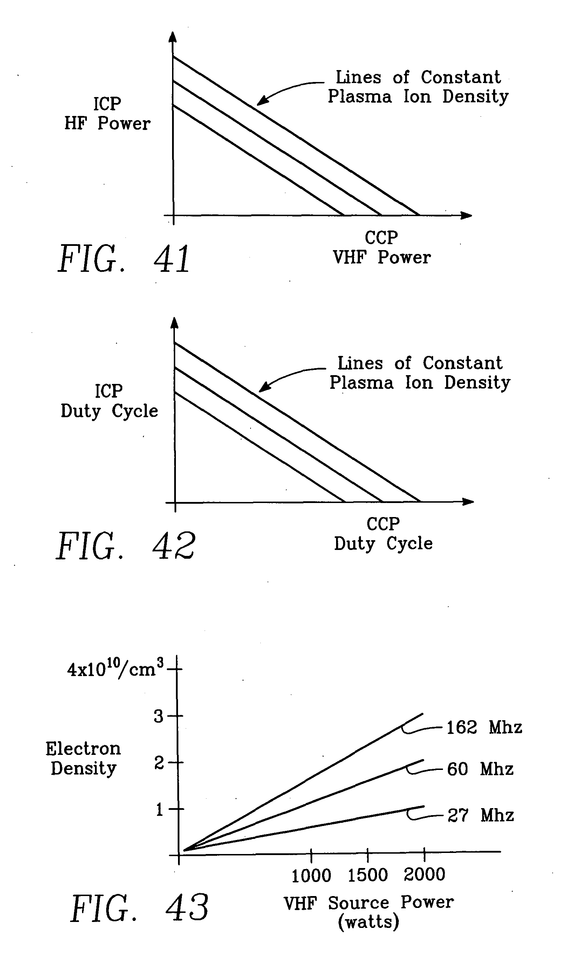

The foregoing adjustments to the ion density distribution can be carried out without changing plasma ion density. FIG. 41 illustrates how this is accomplished in the embodiment of FIG. 39 in which uniformity adjustments are made by adjusting RF generator output power. FIG. 41 depicts lines of constant ion density for different combinations of inductively coupled power (vertical axis) and capacitively coupled power (horizontal axis). Provided that the values of inductively and capacitively coupled power from the generators 1118, 1122 respectively are constrained to lie along a particular one of the lines of constant density, the inductive-capacitive power ratio may be set to any desired value (in order to control uniformity) without changing the plasma ion density. The lines of constant density are deduced for any given reactor by conventional testing. FIG. 42 illustrates how this is accomplished in the embodiment of FIG. 40 in which uniformity adjustments are made by adjusting RF generator pulsed duty cycle. FIG. 42 depicts lines of constant ion density for different combinations of inductively coupled duty cycle (vertical axis) and capacitively coupled duty cycle (horizontal axis). Provided that the values of inductively and capacitively coupled duty cycles from the generators 1118, 1122 respectively are constrained to lie along a particular one of the lines of constant density, the inductive-capacitive power ratio may be set to any desired value (in order to control uniformity) without changing the plasma ion density. The lines of constant density are deduced for any given reactor by conventional testing.

FIG. 43 is a graph depicting the effect of the selection of the frequency of the VHF capacitively coupled power source 1122 upon ion density, in the step of block 1210c of FIG. 37. FIG. 43 shows that ion density (and hence power coupling) increases with applied source power at a greater rate as the frequency is increased (e.g., from 27 MHz, to 60 MHz and then to 200 MHz). Thus, one way of affecting plasma ion density and the balance between capacitive and inductively coupled power is to select or control the VHF frequency of the capacitively coupled source RF generator 1122.

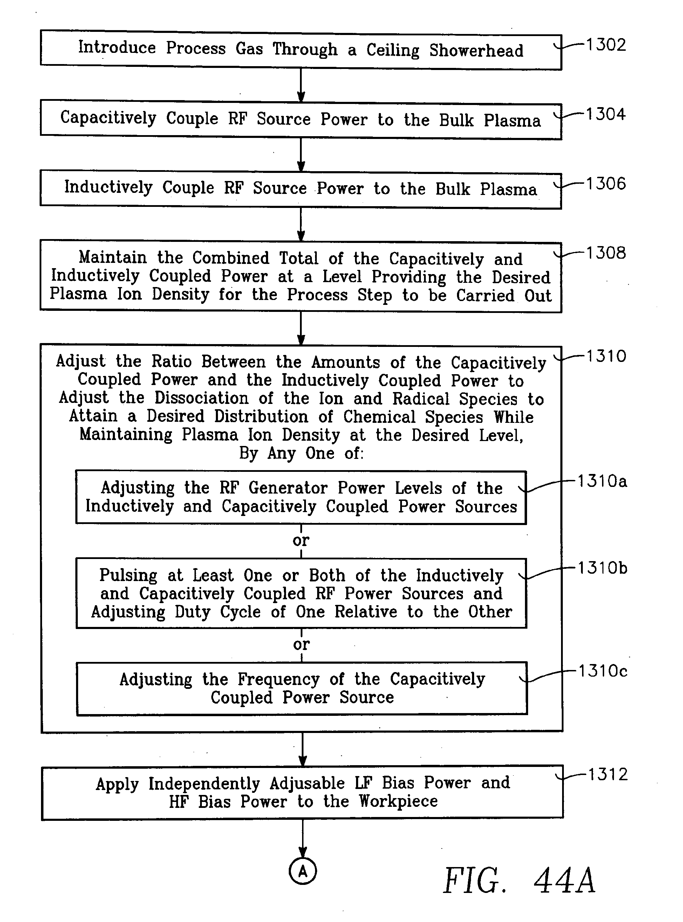

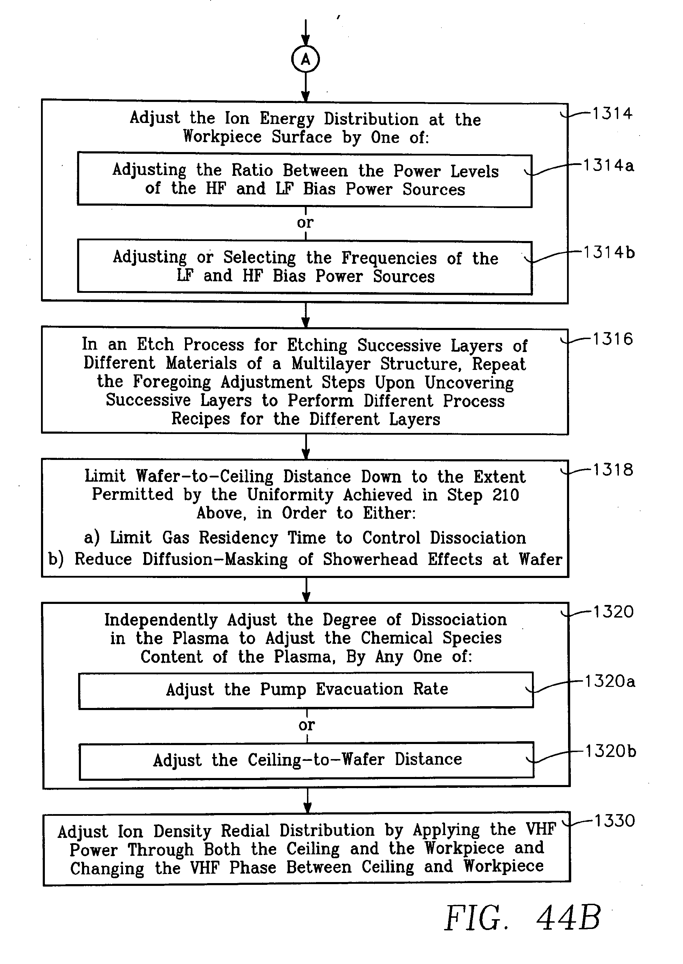

FIG. 44 depicts a modification of the method of FIG. 37 in which a desired plasma ion density is maintained while the inductive-to-capacitive coupling ratio discussed above is employed to achieve a desired level of dissociation or chemical species content of the plasma. The method of FIG. 44 includes introducing process gas, preferably through the ceiling gas distribution showerhead 1109 (block 1302 of FIG. 44). The method continues by capacitively coupling RF source power to the bulk plasma (block 1304) while inductively coupling RF source power to the bulk plasma (block 1306). The user establishes a certain plasma ion density in accordance with a particular process step. This is accomplished by maintaining the combined total of the capacitively coupled power and the inductively coupled power at a level providing the desired plasma ion density for the process step to be carried out (block 1308). At the same time, the degree of dissociation in the bulk plasma is determined (e.g., to satisfy a certain process requirement) while maintaining the desired plasma ion density. This is accomplished by adjusting the ratio between the amounts of the VHF capacitively coupled power and the inductively coupled power (block 1310). This fixes the dissociation (kinetic electron energy in the bulk plasma) between a very high level characteristic of an inductively coupled plasma and a lower level characteristic of a VHF capacitively coupled plasma. Such apportionment can be accomplished without perturbing the ion density by maintaining the total RF power nearly constant while changing only the ratio between the power delivered by the HF and VHF generators 1118, 1122, in accordance with the methods described above with reference to FIG. 41 and (or) FIG. 42. The adjustment of step 1310 can be carried out by any one (or a combination) of the following step: A first type of adjustment consists of adjusting the RF generator power levels of the inductively and capacitively coupled power sources 1118, 1122 (block 1310a of FIG. 44). Another type consists of pulsing at least one or both of the inductively and capacitively coupled RF power generators 1118, 1122 and adjusting the duty cycle of one relative to the other (block 1310b of FIG. 44). A third type consists of adjusting the effective frequency of the capacitively coupled power VHF generator 1122 (block 1310c of FIG. 44), in which plasma ion density increases as the VHF frequency is increased. Changing the effective VHF frequency can be carried out by providing a pair of fixed frequency VHF generators 1122a, 1122b having respective frequencies and adjusting the ratio between their output power levels.

The method further includes coupling independently adjustable LF bias power and HF bias power supplies to the workpiece (block 1312). The controller 1142 adjusts the ion energy level and ion energy distribution (width or spectrum) at the workpiece surface by simultaneous adjustments of the two RF bias power generators 1132, 1134 (block 1314). This step is carried out by any one of the following: One way is to adjust the ratio between the power levels of the HF and LF bias power sources 1132, 1134 (block 1314a of FIG. 44). Another way is to adjusting or selecting the frequencies of the LF and HF bias power sources (block 1314b of FIG. 44).

The method is useful for performing plasma enhanced etch processes, plasma enhanced chemical vapor deposition (PECVD) processes, physical vapor deposition processes and mask processes. If the method is used in an etch process for etching successive layers of different materials of a multilayer structure, the plasma processes for etching each of the layers may be customized to be completely different processes. One layer may be etched using highly dissociated ion and radical species while another layer may be etched in a higher density plasma than other layers, for example. Furthermore, if chamber pressure is changed between steps, the effects of such a change upon radial ion density distribution may be compensated in order to maintain a uniform distribution. All this is accomplished by repeating the foregoing adjustment steps upon uncovering successive layers of the multilayer structure (block 316).

The superior uniformity of plasma ion radial distribution achieved by combining inductively coupled source power and VHF capacitively coupled source power makes it unnecessary to provide a large ceiling-to-wafer distance. Therefore, the ceiling-to-wafer distance may be reduced without compromising uniformity. This may be done when the reactor is constructed, or (preferably) the wafer support 1103 may be capable of being lifted or lowered relative to the ceiling 1108 to change the ceiling-to-wafer distance. By thus decreasing the chamber volume, the process gas residency time is decreased, providing independent control over dissociation and plasma species content. Also, reducing the ceiling-to-wafer distance permits the gas distribution effects of the gas distribution showerhead 1109 to reach the wafer surface before being masked by diffusion, a significant advantage. Thus, another step of the method consists of limiting the ceiling-to-wafer distance to either (a) limit residency time or (b) prevent the showerhead gas distribution pattern from being masked at the wafer surface by diffusion effects (block 1318 of FIG. 44).

The chemical species content of the plasma may be adjusted or regulated independently of the foregoing adjustments by adjusting the process gas residency time in the chamber, in the step of block 1320 of FIG. 44. This step may be carried out by adjusting the rate at which the chamber 1104 is evacuated by the vacuum pump 1160 (block 1320a of FIG. 44), for example by controlling the valve 1162, in order to change the process gas residency time in the chamber. (Dissociation increases with increasing residency time.) Alternatively (or additionally), the adjustment of dissociation may be carried out by adjusting the ceiling-to-wafer distance so as to alter the process gas residency time in the chamber (block 1320b of FIG. 44). This may be accomplished by raising or lowering the workpiece support 1102 of FIG. 36. The foregoing measures for adjusting dissociation in the plasma do not significantly affect the ratio of inductive and capacitive coupling that was established in the step of block 1310. Thus, the adjustment of the dissociation or chemical species content of step 1320 is made substantially independently of (or in addition to) the adjustment of dissociation of step 1210.

In an alternative embodiment, the capacitively coupled source power applicator 1116 consists of electrodes in both the ceiling 1108 and the workpiece support 1103, and VHF power is applied simultaneously through the electrodes in both the ceiling 1108 and the workpiece support 1103. The advantage of this feature is that the phase of the VHF voltage (or current) at the ceiling may be different from the phase at the workpiece support, and changing this phase different changes the radial distribution of plasma ion density in the chamber 1104. Therefore, the radial distribution of plasma ion density may be adjusted independently of the dissociation (i.e., without changing the capacitive-to-inductive coupling ratio selected in the step of block 1310) by adjusting the phase difference between the VHF voltage (or current) at the workpiece support 1103 and the VHF voltage (or current) at the ceiling 1108. This is indicated in block 1330 of FIG. 44.

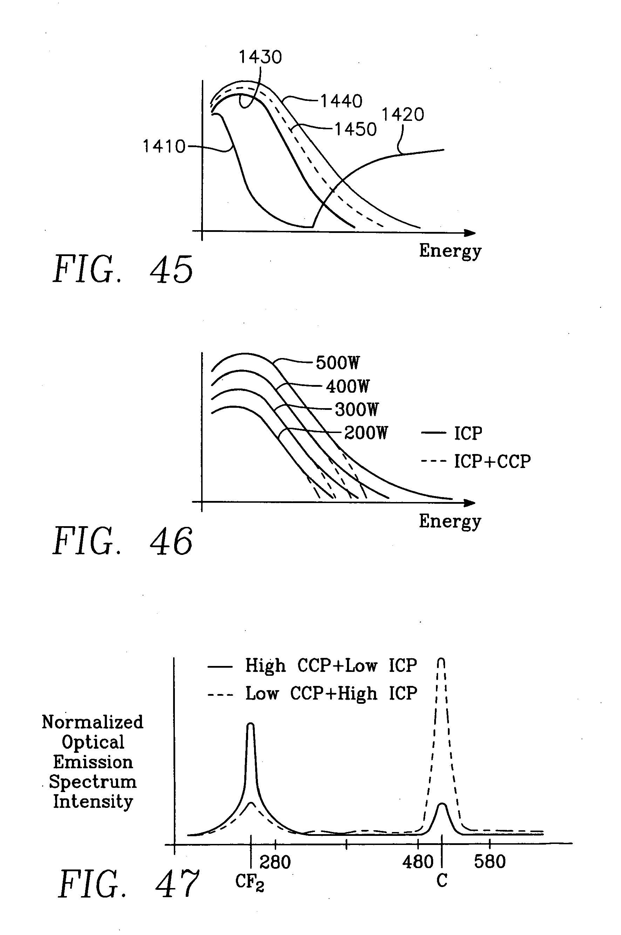

FIG. 45 is a graph depicting how the ratioing of inductive and capacitive coupling controls dissociation in the bulk plasma in the step of block 1308. Dissociation is promoted by an increase in electron energy within the bulk plasma, and FIG. 45 depicts the electron energy distribution function for four different operating regimes.

The curve labeled 1410 depicts the electron energy distribution function in the case in which only the HF bias power is applied to the wafer and no source power is applied. In this case, the electron population is confined within a low energy spectrum, well below an energy at which the cross-section for a typical dissociation reaction (represented by the curve 1420) has an appreciable magnitude. Therefore, less (if any) dissociation occurs.

The curve labeled 1430 depicts the electron energy distribution function in the case in which VHF power is applied to the capacitively coupled source power applicator 1116 and no power is applied to any other applicator. In this case, the electron population has a small component coinciding with the collision cross-section 1420 and so a small amount of dissociation occurs.

The curve labeled 1440 depicts the electron energy distribution function in the case in which HF power is applied to the inductively coupled source power applicator 1114 and power is applied to no other applicator. In this case, the electron population has a component coinciding with a high value of the collision cross-section 1420, and therefore a very high degree of dissociation occurs in the bulk plasma.

The curve labeled 1450 depicts the electron energy distribution function for a case in which RF power is apportioned between the capacitive and inductively coupled applicators 1116, 1114. In this case, the resulting electron energy distribution function is mixture of the two functions 1430, 1440 and lies between them, so that a lesser amount of ion dissociation occurs in the bulk plasma. The curve 1450 representing the combined case has a somewhat smaller electron population at or above an energy at which the collision cross-section 1420 has a significant magnitude, leading to the lesser degree of dissociation. The combination case curve 1450 can be shifted toward greater or lesser energy levels by changing the ratio between the amounts of capacitive and inductive coupled power. This is depicted in the graph of FIG. 46 in which each solid line curve corresponds to the electron energy distribution function for purely inductively coupled power at a particular power level. The dashed line curves extending from the solid line curves depict the modification of those curves as more power is diverted away from inductive coupling and applied to capacitive coupling. Essentially, this causes the electron population to shift to lower energy levels, thereby decreasing dissociation.

FIG. 47 illustrates the effects of different levels of dissociation upon the chemical content of the plasma. The vertical axis represents the optical emission spectrum intensity and the horizontal axis represents wavelength. Different peaks correspond to the presence of certain radicals or ions, and the magnitude of the peak corresponds to the population or incidence in the plasma of the particular species. The solid line curve corresponds to a low degree of dissociation (capacitive coupling predominant), in which larger molecular species are present in large numbers. The dashed line curve corresponds to a high degree of dissociation (inductive coupling predominant), in which smaller (more reactive) chemical species are present in large numbers (depending upon the parent molecule). In the example illustrated in FIG. 47, a large molecular-weight species with high incidence in the predominantly capcitively coupled regime is CF2, while a low molecular-weight species with high incidence in the predominantly inductively coupled regime is free carbon C. In some cases, the presence of C (free carbon) is an indicator of the presence of very light and highly reactive species, such as free fluorine, which may be desirable where a high etch rate is desired. The presence of the larger species such as CF2 is an indicator of less dissociation and an absence of the more reactive species, which may be desirable in a plasma etch process requiring high etch selectivity, for example.

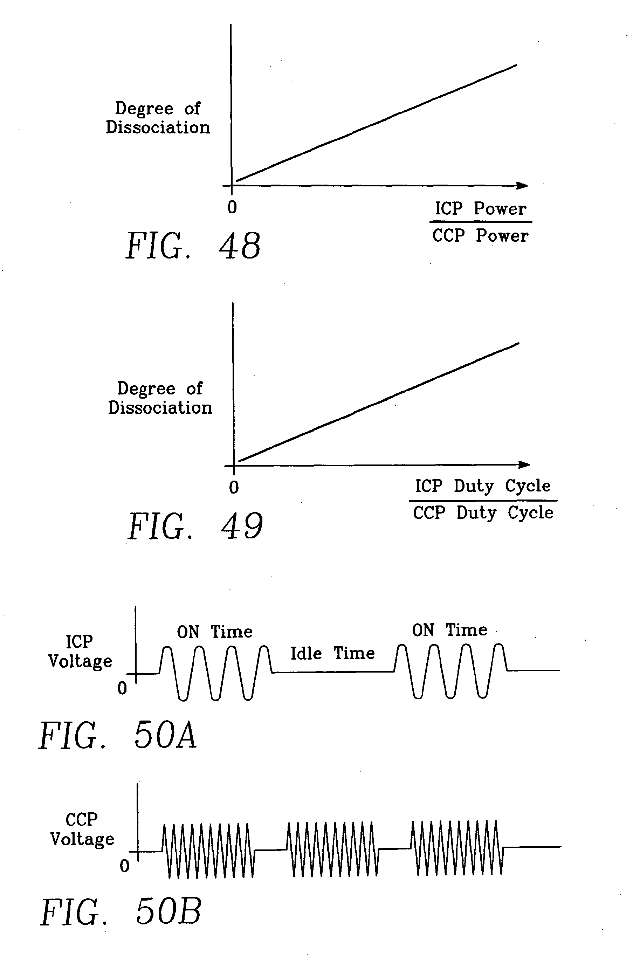

FIG. 48 is a graph illustrating one way of carrying out the step of block 1310a of FIG. 44. The vertical axis of FIG. 48 corresponds to the degree of dissociation in the bulk plasma, and may represent the optical emission spectrum intensity of a highly dissociated species such as free carbon in FIG. 47. The horizontal axis is the ratio of inductively coupled plasma (ICP) power to capacitively coupled plasma (CCP) power (the power levels of the ICP and CCP generators 1118, 1122 of FIG. 36). FIG. 48 indicates that the dissociation is a generally increasing function of this ratio, although it may not be the simple linear function depicted in FIG. 48.

FIG. 49 is a graph illustrating one way of carrying out the step of block 1310b of FIG. 44. The vertical axis of FIG. 49 corresponds to the degree of dissociation in the bulk plasma, and may represent the optical emission spectrum intensity of a highly dissociated species such as free carbon in FIG. 47. The horizontal axis is the ratio of inductively coupled plasma (ICP) pulsed duty cycle to capacitively coupled plasma (CCP) pulsed duty cycle (the pulsed duty cycles of the ICP and CCP generators 1118, 1122 of FIG. 36). FIG. 49 indicates that the dissociation is a generally increasing function of this ratio, although it may not be the simple linear function depicted in FIG. 49. The CCP generator 1122 may not be pulsed, in which case its duty cycle is 100%, while only the ICP duty cycle is varied to exert control. FIGS. 50A and 50B illustrate one possible example of the contemporaneous waveforms of the pulsed ICP generator output and the pulsed CCP generator output. In this illustrated example, the CCP generator 1122 has a higher duty cycle than the ICP generator 1118, so that the plasma is likely to exhibit more the characteristics of a capacitively coupled plasma, such as a low degree dissociation. The ratio between the duty cycles of the capacitively and inductively coupled power sources affects the proportion between inductively and capacitively coupled power in the plasma in the following way. First, the shorter the duty cycle of the inductively coupled power source, the longer the idle time between the pulsed bursts of RF inductive power. During the idle time, the highest energy electrons in the bulk plasma loose their energy faster than other less energetic electrons, so that the electron energy distribution function (FIG. 45) shifts downward in energy (i.e., to the left in FIG. 45). This leads to a more capacitively coupled-like plasma (i.e., less dissociation) during each idle time. This effect increases as duty cycle is decreased, so that the plasma has (on average over many cycles) less high energy electrons, leading to less dissociation. During the idle time, the higher energy electron distribution decays, and (in addition) spatial distribution of the higher energy electrons has an opportunity to spread through diffusion, thus improving process uniformity to a degree depending upon the reduction in inductively coupled power duty cycle.

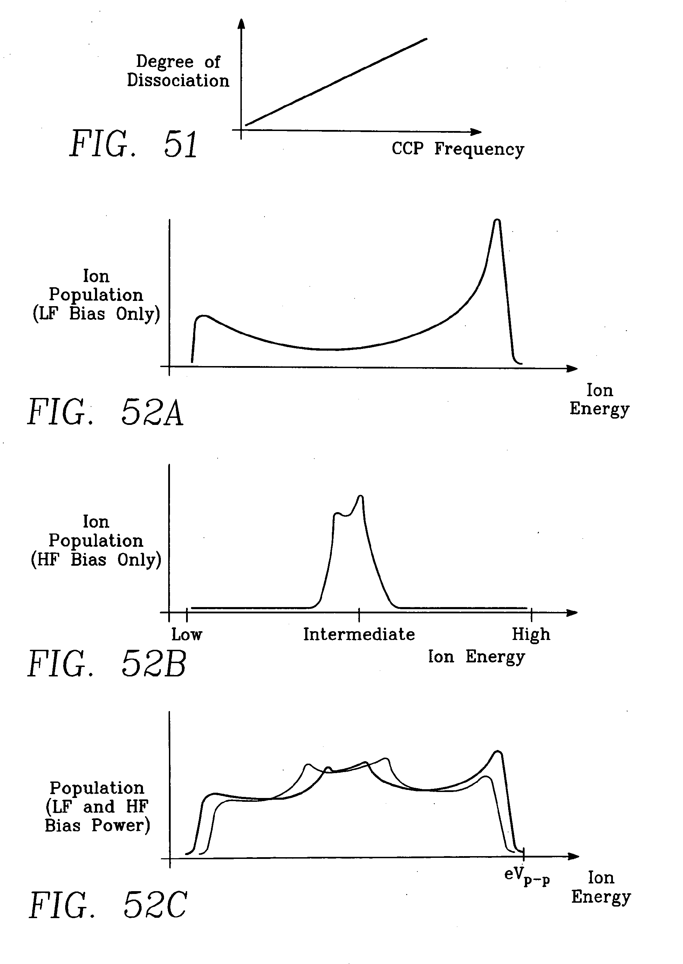

FIG. 51 is a graph depicting one way of carrying out the step of block 1310c of FIG. 44. The vertical axis of FIG. 51 corresponds to the degree of dissociation in the bulk plasma, and may represent the optical emission spectrum intensity of a highly dissociated species such as free carbon in FIG. 47. The horizontal axis is the frequency of the capacitively coupled plasma (CCP) generator 1122 of FIG. 36. FIG. 51 corresponds to the case in which both CCP and ICP power is applied simultaneously, as in the previous examples, and the frequency of the CCP power generator 1122 is increased. For a fixed level of ICP power and a fixed level of CCP power, increasing the effective VHF frequency increases the plasma dissociation, as indicated in FIG. 51. The dissociation behavior may not be the simple linear function depicted in FIG. 51.

FIGS. 52A, 52B and 52C illustrate how the step of block 1214 of FIG. 37 (which corresponds to or is the same as the step of block 1314 of FIG. 44) is carried out. Each of the graphs of FIGS. 52A, 52B, 52C depicts the population of ions at the plasma sheath (at the workpiece surface) as a function of ion energy, or the sheath ion energy distribution.

FIG. 52A depicts the ion energy distribution in the case in which the only bias power that is applied to the wafer is a low frequency (e.g., 1 MHz) bias voltage or current. (In FIG. 36, this corresponds to the case in which only the LF bias power generator 1132 applies bias power.) This frequency is substantially below the sheath ion transit frequency, which is the highest frequency at which the sheath ions can follow an oscillation of the sheath electric field. Therefore, the sheath ions in the example of FIG. 52A can follow the peak-to-peak oscillations of the sheath electric field imposed by the bias power. This results in a peak ion energy that coincides with the RF bias power peak-to-peak voltage (labeled eVp-p in FIG. 52A). The ion energy distribution is bi-modal and has a second peak at a much lower energy, as depicted in the graph of FIG. 52A. The ion distribution between these two peaks is relatively low.

FIG. 52B depicts the ion energy distribution in the case in which the bias power consists only of a high frequency (HF) component (such as 13.56 MHz). (In FIG. 36, this corresponds to the case in which only the HF bias power generator 1134 applies bias power.) This frequency is well above the sheath ion transit frequency, and therefore the sheath ions are unable to follow the peak-to-peak sheath electric field oscillation. The result is that the ion energy distribution of FIG. 52B is confined to a narrow energy band centered at half of the peak-to-peak voltage of the sheath. The ion energy distributions of FIGS. 52A and 52B can be seen to be somewhat complementary to one another, with one distribution (FIG. 52B) being rich in a middle frequency band while the other (FIG. 52A) peaks at two extremes, has a wide distribution that is somewhat depleted at the middle frequencies.

FIG. 52C illustrates an example of an ion energy distribution that can be realized by applying both LF and HF bias power simultaneously (by enabling both bias power generators 1132, 1134 of FIG. 36). This results in an ion energy distribution that is, in effect, a superposition of the two extreme distributions of FIGS. 52A and 52B. The "combination" ion energy distribution of FIG. 52C is therefore adjustable by adjusting the relative amounts of LF and HF bias power. This is accomplished by either (or both) apportioning the power levels of the LF and HF bias power generators 1132, 1134 (as in step 1214a of FIG. 37) or pulsing one or both of them and apportioning their duty cycles (as in step 1214b of FIG. 37). Alternatively, or as an additional step, the frequency of either the HF or the LF bias power may be changed. For example, the LF bias power frequency may be increased to a value closer to the sheath ion transit frequency, which would reduce the ion energy distribution population near the maximum energy (eVp-p) in FIG. 52C (thereby narrowing the ion energy distribution as indicated by the dotted line curve of FIG. 52C). As another example, the HF bias power frequency can be reduced to a value closer to the sheath ion transit frequency, which would decrease the distribution peak at the intermediate energies of FIG. 52C (thereby broadening the ion energy distribution in the middle frequencies as indicated by the dashed line of FIG. 52C).

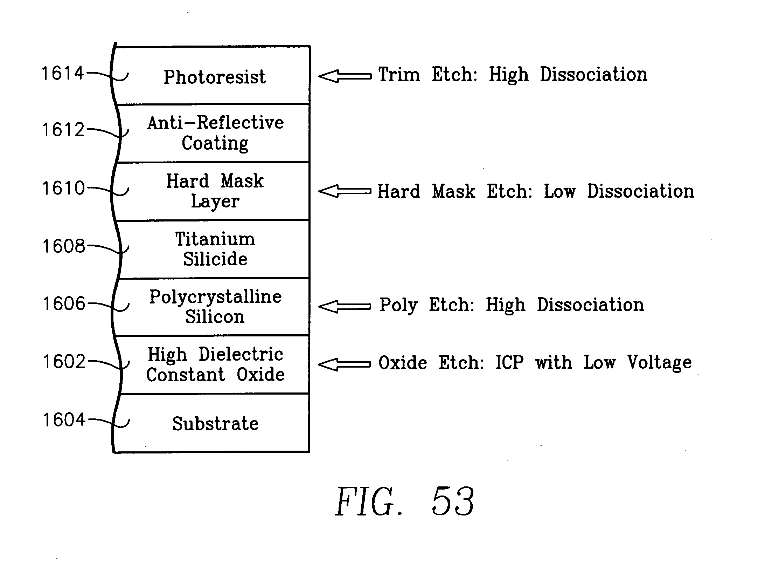

FIG. 53 depicts a multilayer thin film structure of a typical gate of a typical field effect transistor (FET). These layers include a high dielectric constant silicon dioxide layer 1602 overlying a semiconductor substrate 1604, a polycrystalline silicon conductive layer 1606 on the oxide layer 1602, a titanium silicide layer 1608 on the conductive layer 1606, a hard mask layer 1610 over the silicide layer 1608, an anti-reflective (AR) coating 1612 on the hard mask layer 1610 and a photoresist layer 1614 on the AR coating 1612. In a plasma etch process for etching such a structure, the different materials of each of the layers 1602-1614 is best etched in a different etch process. Some of the layers (e.g., the photoresist layer 1614 and the polycrystalline silicon conductive layer 1606 are best etched in a plasma that is more inductively coupled than capacitively coupled, while other layers (e.g., the hard mask layer 1610) are best etched in plasma that is more capacitively coupled than inductively coupled. Using the methods of FIG. 37 or FIG. 44, each of the different layers may be processed (e.g., etched) with the type of plasma process conditions that are optimal for that particular layer, by changing the process conditions, including the type of source power coupling (i.e., changing the ratio between inductively and capacitively coupled source power). Thus, in an etch process, as each successive layer 1602-1614 is exposed, the adjustments described with reference to FIGS. 36 and 44 are repeated to change the process parameters to customize the process for each layer. This is the goal of the step of blocks 1216 and 1316 of FIGS. 37 and 44 respectively. In making such changes, other process parameters may be changed. For example, a predominantly inductively coupled plasma of the type used to etch the polycrystalline layer 1606 may be better maintained at a lower chamber pressure (e.g., a several milliTorr), while a predominantly capacitively coupled plasma may be better maintained at a higher chamber pressure (e.g., tens of milliTorr). Plasmas having nearly the same amount of inductively and capacitively coupled power may be operated at chamber pressures intermediate the higher chamber pressure range of a capacitively coupled plasma and the lower pressure range of an inductively coupled plasma. Moreover, different bias power levels and ion energy distributions may be employed to etch different ones of the layers 1602-1614, using the steps of blocks 1214 or 1314 of FIGS. 36 or 44 to make the adjustments.

### Advantages:

The simultaneous application of both VHF capacitively coupled power and inductively coupled power to the plasma enables the user to independently control plasma ion density and either plasma uniformity or dissociation (or chemical species content of the plasma). Conventional reactors compensate for the center-low ion density distribution of an inductively coupled plasma by applying power from the ceiling using a high ceiling-to-wafer distance so that diffusion effects produce a uniform plasma ion distribution at the wafer. However, such a large ceiling-to-wafer distance would mask the desired effects of an overhead gas distribution showerhead at the wafer surface, so that the benefits of an overhead gas distribution showerhead could not be realized in an inductively coupled reactor. Another problem is that the large ceiling-to-wafer spacing renders the chamber volume very large, so that the process gas residency time is correspondingly large (unless an extremely high capacity vacuum pump evacuates the chamber), making it difficult to control dissociation in the bulk plasma below a minimum level. This has made it more difficult to minimize or solve etch processing problems such as etch microloading or lack of etch selectivity. These problems are all solved in the invention. The seeming inability to employ an overhead gas showerhead in an inductively coupled reactor to improve process uniformity at the wafer surface is solved by introducing an ideal amount of capacitively coupled power to make the ion distribution uniform in the ion generation region. This permits the ceiling-to-wafer spacing to be greatly reduced to the point that an overhead gas showerhead controls process uniformity at the wafer surface. Etch selectivity is improved and etch microloading is reduced by reducing dissociation in the plasma through the reduced gas residency time of the smaller chamber volume facilitated by the reduced ceiling-to-wafer distance. In addition, the etch microloading problem may be solved by independent means by selecting a desired chemical content of the plasma by promoting the degree of dissociation that promotes the desired chemical species. Certain chemical species can suppress the effects of etch microloading, and by adjusting the ratio of the capacitively coupled power to inductively coupled power, the dissociation may be varied to maximize the amount of the desired species present in the plasma. Another advantage is that all of this can be performed while maintaining the overall plasma ion density at a desired level, or independently adjusting plasma ion density.

### Apparatus:

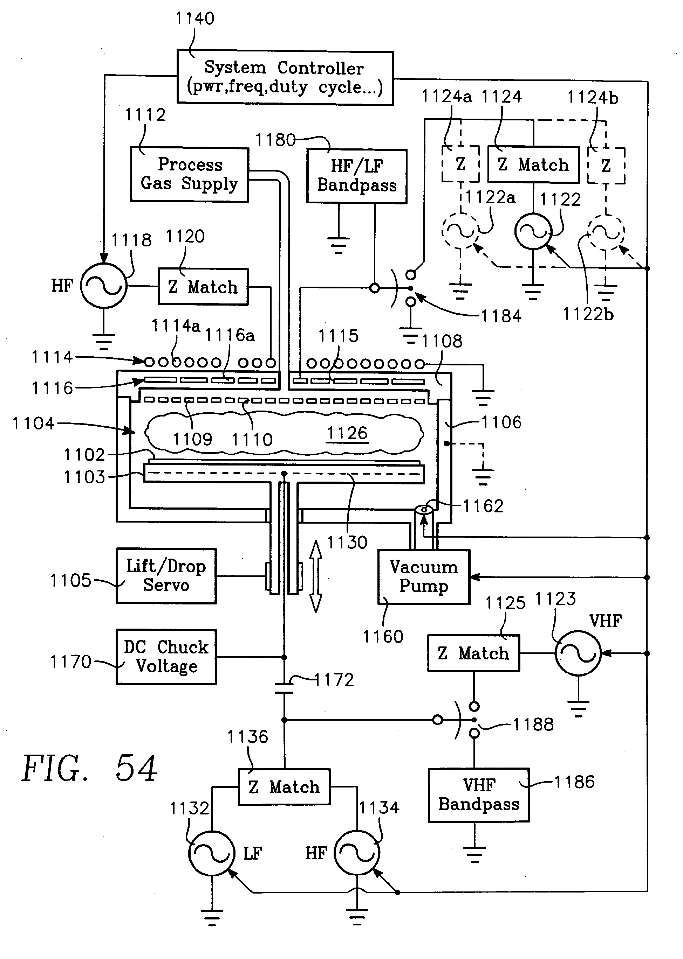

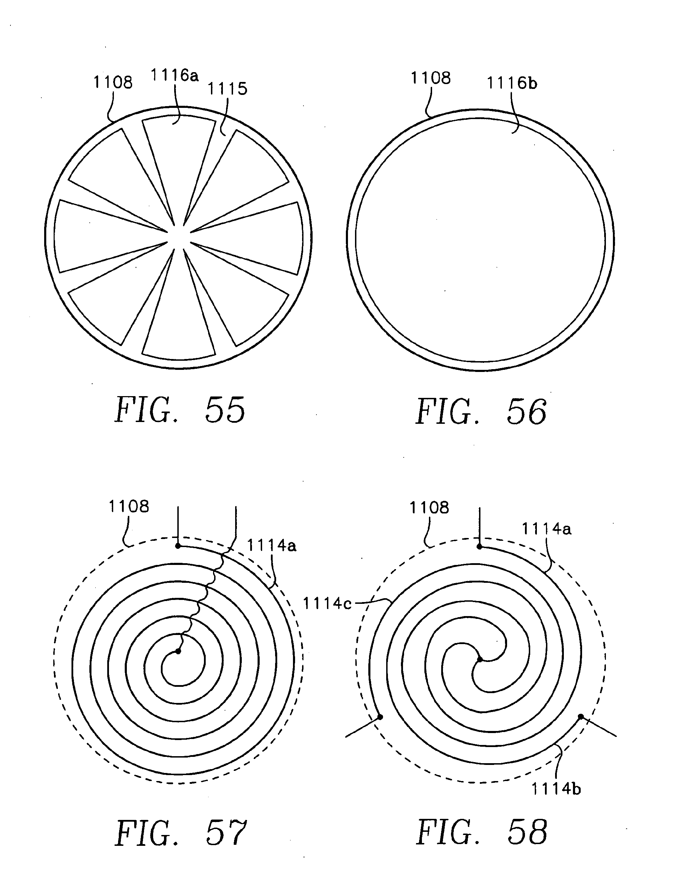

FIG. 54 illustrates a first embodiment of a plasma reactor of the invention for processing a workpiece 1102, which may be a semiconductor wafer, held on a workpiece support 1103 within a reactor chamber 1104. Optionally, the workpiece support 1103 be raised and lowered by a lift servo 1105. The chamber 1104 is bounded by a chamber sidewall 1106 and a ceiling 1108. The ceiling 1108 may include a gas distribution showerhead 1109 having small gas injection orifices 1110 in its interior surface, the showerhead 1109 receiving process gas from a process gas supply 1112. The reactor includes an inductively coupled RF plasma source power applicator 1114. As illustrated in FIG. 57, the inductively coupled power applicator may consist of a conductive coil 1114a wound in a helix and lying over the ceiling 1108 in a plane parallel to the ceiling 1108. Alternatively, as depicted in FIG. 58, the conductive coil may consist of parallel helically wound conductors 1114b, 1114c, 1114d. A capacitively coupled RF plasma source power applicator 1116, in one embodiment, is an electrode 1116a in the ceiling overlying the gas distribution showerhead. In another embodiment, the capacitively coupled plasma source power applicator 1116 is an electrode 1130 within the workpiece support 1130. In order to permit inductive coupling into the chamber 1104 from the coil antenna 1114a, the gas distribution showerhead 1109 may be formed of a dielectric material such as a ceramic. The ceiling electrode 1116a preferably has multiple radial slots 1115 as illustrated in FIG. 55 to permit inductive coupling into the chamber 1104 from the overhead coil antenna 1114a into the chamber. Alternatively, a ceiling electrode 1116b depicted in FIG. 56 may be employed that is not slotted and instead is formed of a material capable of functioning as an electrode while at the same time permitting inductive coupling of RF power from the overhead coil antenna 1114. One example of such a material is a doped semiconductor.

In an alternative embodiment, the capacitively coupled source power applicator 1116 may include both the electrode 1116a within the ceiling 1108 and the electrode 1130 within the workpiece support 1103, so that RF source power may be capacitively coupled simultaneously from the ceiling 1108 and the workpiece support 1103. In yet another alternative embodiment, both electrodes 1116a and 1130 are present, but VHF source power is applied to only one of them while the other serves as an VHF return or counter electrode.

An RF power generator 1118 provides high frequency (HF) power (e.g., within a range of about 10 MHz through 27 MHz) through an impedance match element 1120 to the inductively coupled coil antenna 1114a. In one embodiment in which the ceiling electrode 1116a is the capacitively coupled source power applicator, an RF power generator 1122 provides very high frequency (VHF) power (e.g., within a range of about 27 MHz through 200 MHz) through an impedance match element 1124 to the capacitively coupled power applicator 1116. In another embodiment in which the bottom (workpiece support) electrode 1130 is the capacitively coupled source power applicator, an RF power generator 1123 provides VHF power through an impedance match element 1125 to the bottom electrode 1130. In a third embodiment, both the ceiling and bottom electrodes 1116a, 1130 comprise the capacitively coupled plasma source power applicator, so that both VHF generators 1122, 1123 are present. In a further embodiment, both electrodes 1116a, 1130 are present, but VHF plasma source power is applied to only one them, while the other is coupled to the VHF return potential (e.g., ground) in order to serve as a counterelectrode for the other.

The efficiency of the capacitively coupled power source applicator 1116 in generating plasma ions increases as the VHF frequency increases, and the frequency range preferably lies in the VHF region for appreciable capacitive coupling to occur. Power from both RF power applicators 1114, 1116 is coupled to a bulk plasma 1126 within the chamber 1104 formed over the workpiece support 1103.

RF plasma bias power is coupled to the workpiece 1102 from an RF bias power supply coupled to the electrode 1130 inside the workpiece support and underlying the wafer 1102. The RF bias power supply may include a low frequency (LF) RF power generator 1132 (100 kHz to 4 MHz) and another RF power generator 1134 that may be a high frequency (HF) RF power generator (4 MHz to 27 MHz). An impedance match element 1136 is coupled between the bias power generators 1132, 1134 and the workpiece support electrode 1130. A vacuum pump 1160 evacuates process gas from the chamber 1104 through a valve 1162 which can be used to regulate the evacuation rate. The evacuation rate through the valve 1162 and the incoming gas flow rate through the gas distribution showerhead 1109 determine the chamber pressure and the process gas residency time in the chamber. If the workpiece support 1103 is an electrostatic chuck, then a D.C. chucking voltage supply 1170 is connected to the electrode 1130. A capacitor 1172 isolates the RF generators 1123, 1132, 1134 from the D.C. voltage supply 1170.

In the first embodiment, VHF power is applied only to the ceiling electrode 1116a. In this case, it may desirable for the workpiece support electrode 1130 to function as the return path for the VHF power applied to the ceiling electrode 1116a and for the ceiling electrode to function as the return path for the HF power applied to the workpiece support electrode 1130. For this purpose, the ceiling electrode 1116a may be connected through an LF/HF bandpass filter 1180 to ground. The bandpass filter 1180 prevents VHF from the generator 1122 from being diverted from the ceiling electrode 1116a to ground. Similarly, the wafer support electrode 1130 may be connected (via the RF isolation capacitor 1172) to ground through a VHF bandpass filter 1186. The VHF bandpass filter 1186 prevents LF and HF power from the generators 1132, 1134 from being diverted from the electrode 1130 to ground.

In the second embodiment, VHF power is applied to only the wafer support electrode 1130. In this case, the wafer support electrode 1130 is not connected to ground, but rather to the VHF generator 1123 (via the match 1125), so that the VHF bandpass filter 1186 is eliminated. Likewise, the LF/HF bandpass filter 1180 may be bypassed (or eliminated) and the ceiling electrode 1116a connected directly to ground. The foregoing options are indicated symbolically by the switches 1184, 1188 in FIG. 54. It is understood that the reactor may be permanently configured in accordance with one of the first or second embodiments rather than being configurable (by the switches 1184, 1188) into either embodiment, so that only one of the VHF generators 1122, 1123 would be present, and the switches 1184, 1188 would be unnecessary in such a case.

In the third embodiment, both electrodes 1116a, 1130 are driven simultaneously by the VHF generators 1122, 1123 so that neither could be a VHF ground. However, the ceiling electrode 1116a could be connected through the LF/HF bandpass filter 1180 to ground in order to be a counterelectrode or return for LF/HF bias power applied to the wafer support electrode 1130. In this embodiment, the side wall 1106 may provide a ground return for the VHF power. If the VHF phase between the two electrodes 1130, 1116a is different, then each electrode may provide some reference potential for at least a portion of each RF cycle. For example, the VHF phase difference between the two electrodes 1116a, 1130 were 180 degrees, then each electrode 1116a, 1130 would function as a counterelectrode for the other during the entirety of each RF cycle. The two VHF generators 1122, 1123 may be realized in a single VHF generator, with a source power controller 1140 governing the difference in phase between the VHF voltages or the VHF currents delivered by the single generator to the respective electrodes 1116b, 1130.

The source power controller 1140 regulates the source power generators 1118, 1122 independently of one another in order to control bulk plasma ion density, radial distribution of plasma ion density and dissociation of radicals and ions in the plasma. The controller 1140 is capable of independently controlling the output power level of each RF generator 1118, 1122. In addition, or alternatively, the controller 1140 is capable of pulsing the RF output of either one or both of the RF generators 1118, 1122 and of independently controlling the duty cycle of each, or of controlling the frequency of the VHF generator 1122 and, optionally, of the HF generator 1118. The controller 1140 may also control the pumping rate of the vacuum pump 1160 and/or the opening size of the evacuation valve 1162. In addition, a bias power controller 1142 controls the output power level of each of the bias power generators 1132, 1134 independently. The controllers 1140, 1142 are operated to carry out the various methods of the invention described above.

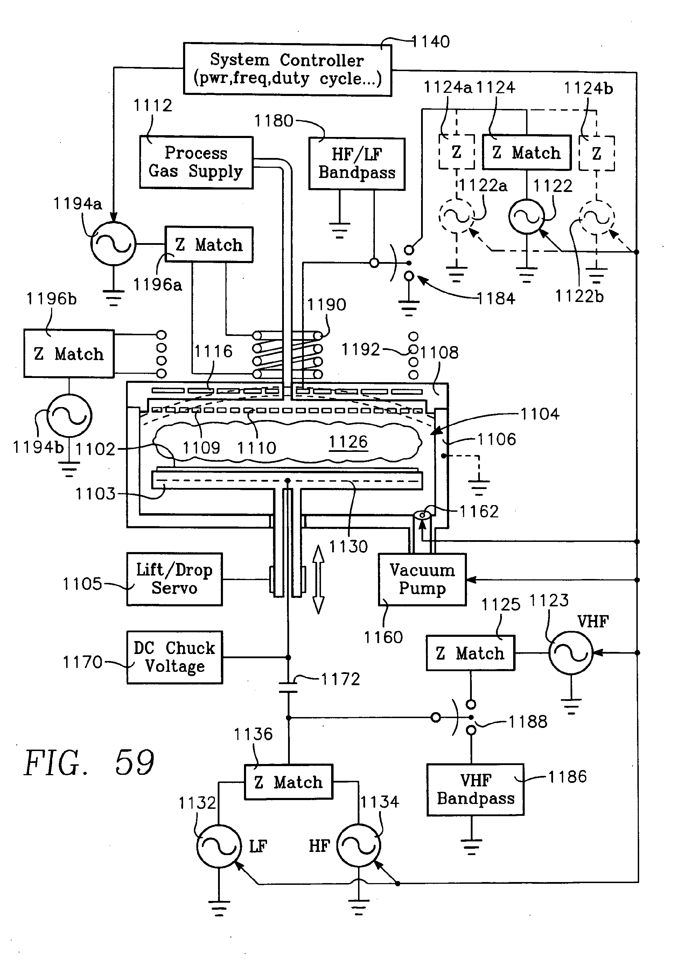

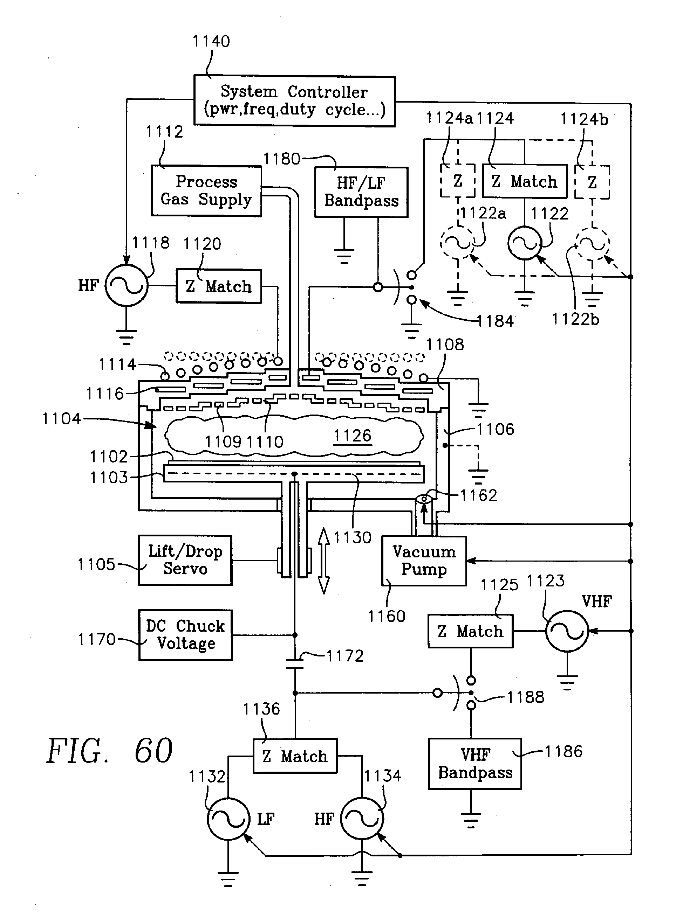

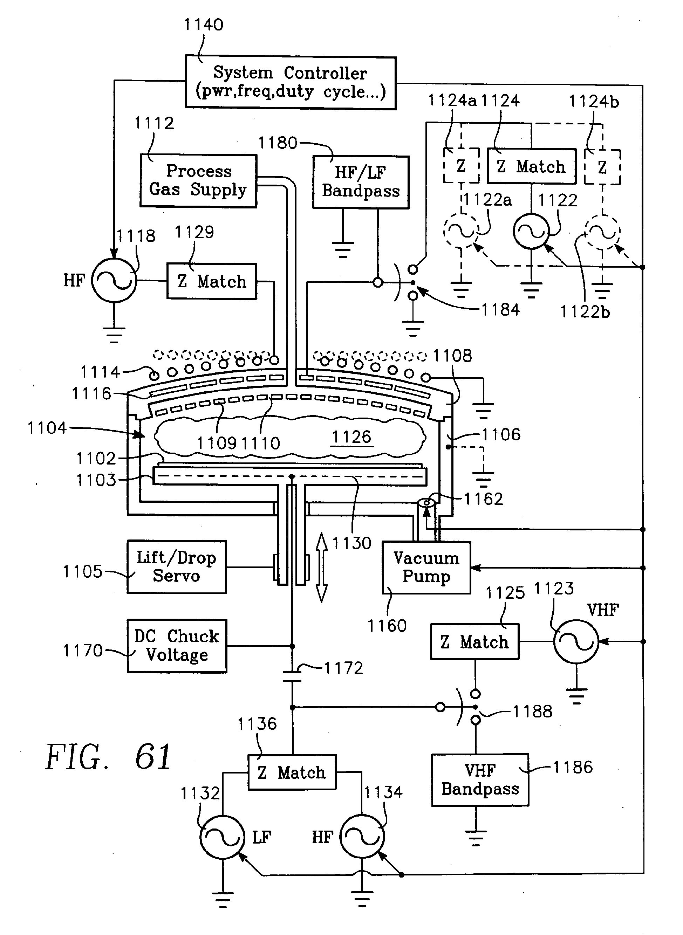

FIG. 59 illustrates another modification of the embodiment of FIG. 54 in which the coil antenna 1114a includes one (or more) solenoidal conductor windings 1190, 1192 fed by respective RF generators 1194a, 1194a through respective impedance matches 1196a, 1196b. In this case, the ceiling 1108 and showerhead 1109 may be either flat (solid line) or dome shaped (dotted line). FIG. 60 depicts a modification of the embodiment of FIG. 54 in which the ceiling 1108 and gas distribution showerhead 1109 have a center-high stepped shaped. In this case the coil antenna 1114a can assume either a flat shape (dotted line) or a hemispherical (or dome) shape as shown in solid line in FIG. 60. FIG. 61 depicts another modification of the embodiment of FIG. 54 in which the ceiling 1108 and the gas distribution showerhead 1109 are hemispherical or dome shaped. Again, the coil antenna 1114a be flat (dotted line) or dome shaped (solid line).

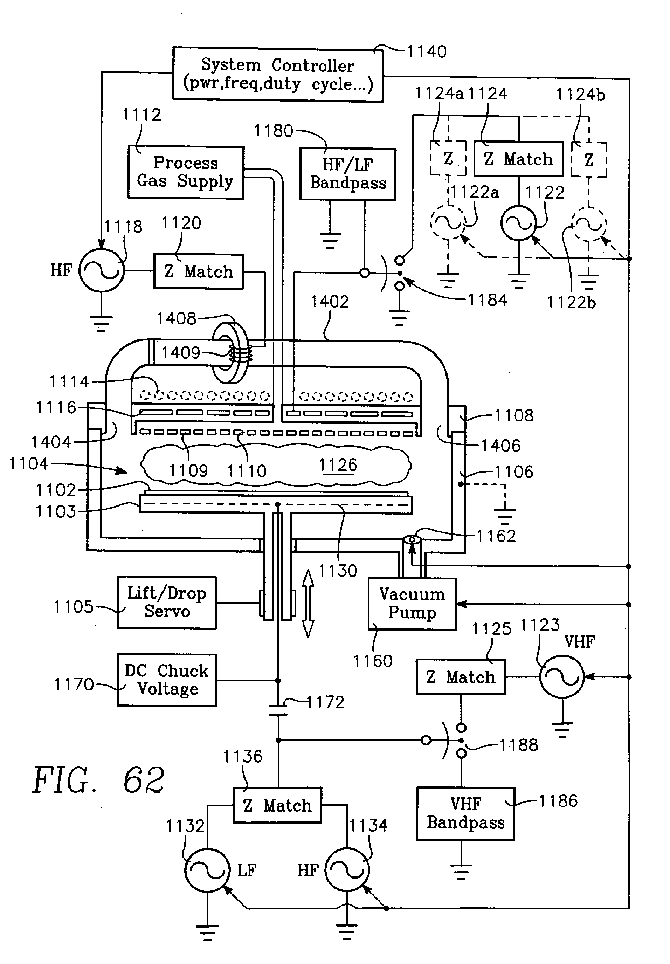

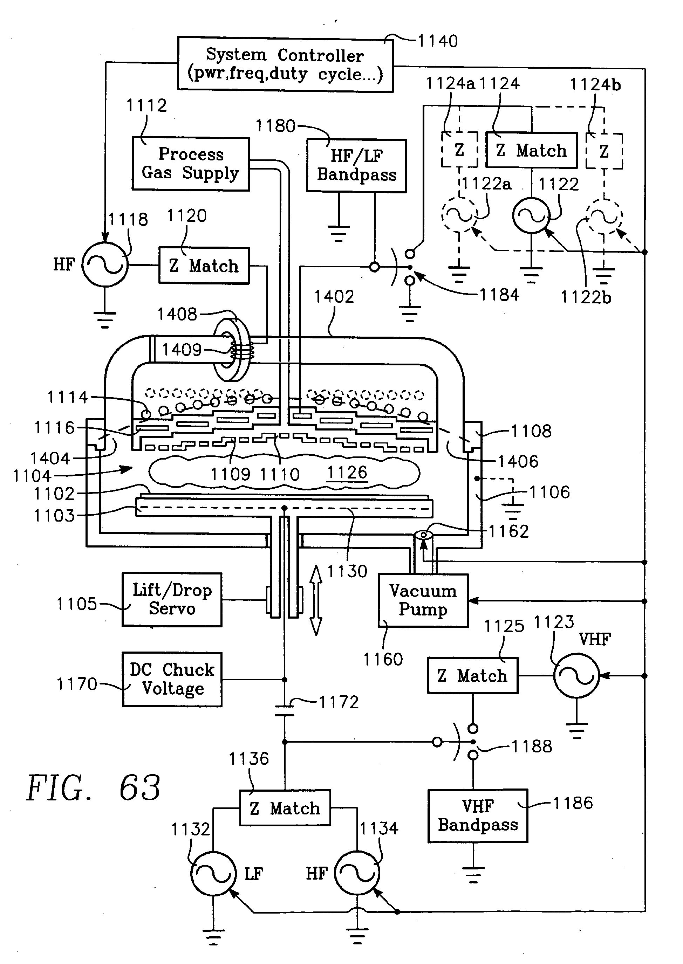

FIG. 62 illustrates another embodiment in which the inductively coupled source power applicator 1114 is a toroidal source rather than an inductive antenna. The toroidal source consists of an external hollow reentrant conduit 1402 coupled to a pair of openings 1404, 1406 in the chamber enclosure that are separated by the diameter of the process region. For example, in the implementation of FIG. 62, the openings 1404, 1406 are through the ceiling 1108 and are at the edge of the chamber so that they are separated by the diameter of the wafer support 1103. RF power is coupled into the interior of the conduit 1402 by means of a magnetic (e.g., iron) toroidal core 1408 having a conductive winding 1409 wrapped around a portion of the core 1408. The RF generator 1118 is coupled through the match 1120 to the winding 1409. This toroidal source forms a plasma current in a circular path that passes through the conduit 1402 and through the processing region overlying the wafer 1102. This plasma current oscillates at the frequency of the RF generator 1118. FIG. 63 depicts a modification of the reactor of FIG. 62 in which the ceiling 1108 and showerhead 1109 are a center high step shape (solid line) or dome shaped (dotted line). One advantage of the toroidal plasma source of FIGS. 27 and 28 is that RF power is not inductive coupled directly through the gas distribution showerhead 1109 nor through the ceiling electrode 1116b. Therefore, the showerhead 1109 may be metal and the ceiling electrode 1116a may be solid (without the slots 1115 of FIG. 55), or the ceiling electrode may be eliminated and the VHF power coupled directly to the metal gas distribution showerhead 1109 so that the metal showerhead 1109 functions as the ceiling electrode.

Each of the reactors of FIGS. 54-61 capacitively couples VHF source power into the chamber while inductively coupling HF source power into the chamber. The reactors of FIGS. 62-63 capacitively couple VHF source power into the chamber and inductively couple HF source power to an oscillating toroidal plasma current that passes through the process region of the chamber. This inductive coupling element faces an external portion of the oscillating toroidal plasma current. The capacitively coupled power is applied in the embodiments of FIGS. 54-61 to the ceiling electrode 1116a or to the wafer support electrode 1116b, and is applied in the embodiments of FIGS. 62-63 to a conductive version of the showerhead 1109 (or to the wafer support electrode 1116b). The capacitively coupled power generates ions in the bulk plasma because it is in the VHF frequency range (27-200 MHz). In this frequency range, kinetic electrons in the bulk plasma follow the capacitively coupled RF field oscillations and therefore acquire sufficient energy to contribute to ion generation. Below this range, the capacitively coupled power would contribute more to ion energy in the plasma sheath rather than to ion generation in the bulk plasma, and therefore would not be plasma source power. Therefore, in order to provide plasma source power (i.e., power for generating ions in the bulk plasma), the RF generator 1122 (or 1123) coupled to the electrode 1116a (or 1130) provides VHF power.

While control over all process parameters has been described as being carried out by two controllers 1140, 1142, it is understood that the controllers may be realized in a single controller that controls all process parameters and adjustments.

The multiple frequency plasma reactor elements of FIGS. 36 and 54 through 61 may be combined with any one or all of the following features in the same plasma reactor: (a) the cathode of FIGS. 1-5 having a highly uniform distribution of electrical properties, (b) the adjustable electrical element within the cathode of FIGS. 6 and 7, (c) the backside optical detection apparatus of FIGS. 8, 14-21 and 25, and (d) the array of modular individually valved injection nozzles of FIGS. 27, 28, 31 and 32. In addition, the controller 140 of FIG. 36 (governing the effective VHF frequency and the ratio of inductively and capacitively coupled power levels can be one of the Tunable Reactor Elements referred to in FIG. 26. In such an arrangement, the effective VHF frequency and/or the ratio of capacitive and inductively coupled power levels may be controlled in a feedback control loop using the backside optical sensor array 300 of FIG. 26. The sensor array 300 may be employed to sense non-uniformities in etch depth or etch rate distribution in real time, and the feedback control loop may act to reduce the non-uniformities during processing.

While the foregoing is directed to embodiments of the present invention, other and further embodiments of the invention may be devised without departing from the basic scope thereof, and the scope thereof is determined by the claims that follow.

## Claims

1. A plasma reactor for processing a workpiece, comprising:
a reactor chamber (10) and a workpiece support (16) within said chamber, said chamber having a ceiling (14) facing said workpiece support;
an inductively coupled plasma source power applicator (1114) overlying said ceiling, and an RF power generator (1118) coupled to said inductively coupled source power applicator;
a capacitively coupled plasma source power applicator (1116) comprising a source power electrode at one of: (a) said ceiling (b) said workpiece support;
an array of passages (231, 23, 249, 320) extending through said workpiece support pedestal (16) from a bottom thereof and forming an array of openings in a support surface of said workpiece support;
an array of optical fibers (234, 244, 252, 330) each extending through a respective one of said passages and having: (a) a viewing end with a field of view through said opening in said support surface, and (b) an output end outside of said chamber;
optical sensors (238, 254, 328) coupled to the output ends of said optical fibers; and
a controller (60) responsive to said optical sensors for adjusting the relative amounts of power simultaneously coupled to plasma in said chamber by said inductively coupled plasma source power applicator and said capacitively coupled plasma source power applicator.

2. The reactor of Claim 1 wherein signals from said optical sensors represent an instantaneous image of etch depth distribution across a surface of a workpiece, and wherein said controller is programmed to adjust said relative amounts of power so as to enhance uniformity of said etch depth distribution.

3. A plasma reactor for processing a workpiece, comprising:
a reactor chamber (10) and a workpiece support (16) within said chamber, said chamber having a ceiling (14) facing said workpiece support;
a capacitively coupled plasma source power applicator (1116) comprising a source power electrode at one of: (a) said ceiling (b) said workpiece support;
plural VHF power generators (1122, 1122a, 1122b) of different fixed frequencies coupled to said capacitively coupled source power applicator;
an array of passages (231, 233, 249, 320) extending through said workpiece support pedestal (16) from a bottom thereof and forming an array of openings in a support surface of said workpiece support;
an array of optical fibers (234, 244, 252, 330) each extending through a respective one of said passages and having: (a) a viewing end with a field of view through said opening in said support surface, and (b) an output end outside of said chamber;
optical sensors (238, 254, 328) coupled to the output ends of said optical fibers; and
a controller (60) responsive to said optical sensors for independently controlling the power output levels of said plural VHF generators so as to control an effective VHF frequency applied to said source power electrode.

4. The reactor of Claim 3 wherein signals from said optical sensors (238, 254, 328) represent an instantaneous image of etch depth distribution across a surface of a workpiece, and wherein said controller (60) is programmed to adjust said relative amounts of power so as to enhance uniformity of said etch depth distribution.

5. The reactor of any of Claims 3 to 4, further comprising: a plasma bias power applicator comprising a bias power electrode (1130) in said workpiece support;
plural RF power generators (1132, 1134) of different fixed frequencies coupled to said plasma bias power applicator; and
a controller responsive to said optical sensors for independently controlling the power output levels of said plural RF generators so as to control an effective RF frequency applied to said plasma bias power applicator.

6. The reactor of any of Claims 3 to 5, further comprising a tunable element within said workpiece support and a control element coupled to said tunable element, said control element being responsive to said optical sensors.

7. A plasma reactor for processing a workpiece, comprising:
a vacuum chamber having (10) a sidewall (12) and a ceiling (14);
a workpiece support pedestal (16) and having a support surface facing said ceiling and lying within said chamber for supporting a workpiece;
an array of passages (231, 233, 249, 320) extending through said workpiece support pedestal from a bottom thereof and forming a two-dimensional array of openings in said support surface;
a plurality of optical fibers (234, 244, 252, 330), each fiber extending through a respective one of said passages and having: (a) a viewing end with a field of view through said opening in said support surface, and (b) an output end outside of said chamber;
optical sensing apparatus (238, 254, 328) coupled to said output ends of said optical fibers;
a tunable element capable of changing a two-dimensional etch rate distribution across the surface of a workpiece supported on said pedestal; and
a process controller (60) connected to receive information from said optical sensing apparatus and to transmit control commands to said tunable element.

8. The reactor of Claim 7 wherein said tunable element comprises:
an array of gas injection ports in communication with said chamber, a process gas supply and a plurality of controllable valves connected between said supply and respective ones of said array of gas injection ports, said process controller coupled to said tunable valves.

9. The reactor of any of Claims 7 to 8, wherein said tunable element comprises:
a hollow opening in said workpiece support pedestal;
a movable metal plate (112) within said hollow opening; and
an actuator (118) for moving the location of said metal plate relative to said support surface, said process controller coupled to said actuator.

10. The reactor of any of Claims 7 to 9, wherein said tunable element comprises:
inner and outer source power applicators (20, 22) overlying said ceiling and an RF power controller for controlling the proportion of RF power levels applied to said inner and outer source power applicators.

11. A plasma reactor for processing a workpiece that is transparent at least within a range of wavelengths, comprising:
a vacuum chamber (10) having a sidewall (12) and a ceiling (14);
a workpiece support pedestal (16) and having a support surface facing said ceiling and lying within said chamber for supporting a workpiece;
a passage (120; 231, 233, 249) extending through said workpiece support pedestal from a bottom thereof and forming an opening through said support surface;
an optical fiber (126; 234, 236; 252) extending through said passage and having: (a) a viewing end with a field of view through said opening in said support surface, and (b) an output end outside of said chamber; and
an optical sensor (130; 238, 254) coupled to said output end of said optical fiber and being responsive in said range of wavelengths.

12. The reactor of Claim 11 further comprising a lens (122; 230, 232, 250) in said passage at least near said support surface and having an optical axis extending through said opening in said support surface, said viewing end of said optical fiber facing said lens at or near said optical axis.

13. The reactor of Claim 12 wherein said viewing end of said optical fiber is coupled to said lens at said optical axis.

14. The reactor of any of Claims 12 to 13, further comprising:
a light source (128; 240) ; and
a second optical fiber (124; 242, 244) having one end lying outside of said chamber and coupled to receive light from said light source and another end coupled to said lens.

15. The reactor of any of Claims 12 to 14, wherein said lens has sufficient power to resolve interference fringes generated in periodically spaced optical features of less than one micron in size on a workpiece supported on said workpiece support.

16. The reactor of any of Claims 11 to 15, further comprising an optical signal processor (132; 256) coupled to said optical sensor (130; 238, 254).

17. The reactor of Claim 16 wherein said optical sensor is capable of sensing an ambient reflected light level, and said optical signal processor is programmed to respond to a large shift in ambient reflected light level as being indicative of an etch process end point.

18. The reactor of Claim 16 wherein said optical sensor is capable of sensing individual interference fringes, and said optical signal processor is programmed to count interference fringes generated on a workpiece supported on said pedestal during an etch process in said reactor.

19. The reactor of Claim 16 wherein said optical sensor is a spectrometer (130; 254), and said optical signal processor is programmed to one of:
(a) compare a multiple wavelength interference spectrum with a known spectrum;
(b) compute etch depth from spacing between spectral peaks in a spectrum produced by said spectrometer;
(c) compare a multiple wavelength interference spectrum generated from said optical sensor with spectra of known etch depths in order to determine etch depth of a current process.

20. The reactor of Claim 16 wherein said optical sensor is an optical emission spectrometer (130; 254), and said optical signal processor is programmed to track a selected spectral line for detecting etch process end point.
